(19) Europäisches Patentamt / European Patent Office / Office européen des brevets

(11) **EP 4 375 681 B1**

(12) **EUROPEAN PATENT SPECIFICATION**

(45) Date of publication and mention
of the grant of the patent:
**26.11.2025 Bulletin 2025/48**

(21) Application number: **22845394.0**

(22) Date of filing: **21.07.2022**

(51) International Patent Classification (IPC):
**G01R 19/25** (2006.01)     **G01R 31/327** (2006.01)
**G01R 19/00** (2006.01)

(52) Cooperative Patent Classification (CPC):
**G01R 19/003; G01R 19/2506; G01R 31/3277;**
G01R 19/25; Y02T 10/70; Y02T 10/7072

(86) International application number:
**PCT/CN2022/107008**

(87) International publication number:
**WO 2023/001230 (26.01.2023 Gazette 2023/04)**

(54) **VOLTAGE FILTERING METHOD FOR DETECTING POINT IN CIRCUIT, SWITCH STATE DETECTING METHOD, AND RELATED APPARATUS**

SPANNUNGSFILTERVERFAHREN ZUR ERKENNUNG EINES SCHALTUNGSPUNKTES, SCHALTZUSTANDSERKENNUNGSVERFAHREN UND ZUGEHÖRIGE VORRICHTUNG

PROCÉDÉ DE FILTRAGE DE TENSION POUR POINT DE DÉTECTION DANS UN CIRCUIT, PROCÉDÉ DE DÉTECTION D'ÉTAT DE COMMUTATEUR ET APPAREIL ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.07.2021 CN 202110839634**

(43) Date of publication of application:
**29.05.2024 Bulletin 2024/22**

(73) Proprietor: **Changchun Jetty Automotive Technology Co., Ltd.**
**Changchun City, Jilin Province 130000 (CN)**

(72) Inventor: **WANG, Chao**
**Changchun City, Jilin 130000 (CN)**

(74) Representative: **Habermann, Hruschka & Schnabel**
**Patentanwälte**
**Montgelasstraße 2**
**81679 München (DE)**

(56) References cited:
CN-A- 109 188 297     CN-A- 109 188 297
CN-A- 110 988 448     CN-A- 110 988 448
CN-A- 112 078 392     CN-A- 112 098 820
CN-A- 112 098 820     CN-A- 113 533 839
US-A1- 2016 178 672

**Description**

RELATED APPLICATION

The present application claims the priority of the Chinese Patent Application No. 202110839634.6, filed on July 23, 2021.

TECHNICAL FIELD

The present disclosure relates to the technical field of new energy, and in particular to a voltage filtering method for a detecting point in a circuit, a switch state detection method and a related apparatus.

BACKGROUND

The voltage filtering for a detecting point (DP) refers to that an analog signal of voltage collected from the detecting point in the circuit is converted into a digital signal and then filtered, to prevent the voltage jitter from causing the control misjudgment of the circuit. Especially for a control guidance unit of a charging base and etc. of new energy vehicles, the reliability of voltage filtering on the detecting point directly determines the detection accuracy of the switch state in the control guidance unit. A filtering method applied to UPS bus voltage sampling is known from the prior art, for example from CN110988448A. A switch state detection circuit, method and device is known from the prior art, for example from CN112098820A.

At present, the existing voltage filtering method for a detecting point configured with a single filter circuit and etc. to filter the ripple in the voltage. However, this method cannot verify the effectiveness of voltage filtering, and thus cannot guarantee the accuracy of subsequent control or detection based on the filtered voltage.

SUMMARY

Aiming at the problems in the prior art, the present disclosure provides a method and a related apparatus for voltage filtering for a detecting point in a circuit and a switch state detection, all of which may effectively verify the validity of the voltage filtering for the detecting point in the circuit, and then ensure the reliability of the voltage filtering for the detecting point, and then effectively improve the accuracy and reliability of subsequent control or detection based on the filtered voltage. The invention is defined by the independent claims. Further embodiments are defined in the dependent claims. Additional non-claimed embodiments, aspects or examples are also presented in the description for the better understanding of the invention.

BRIEF DESCRIPTION OF THE DRAWINGS

To illustrate more clearly the embodiments of the present disclosure or the technical solutions of the prior art, a brief description of the accompanying drawings in the embodiments or the prior art will be given below. Obviously, the accompanying drawings described below are some embodiments described in this disclosure. For those of ordinary skill in the art, other drawings may also be obtained without any creative labor from these drawings.

FIG. 1 is a schematic diagram of a first flow of a voltage filtering method for a detecting point in a circuit according to an embodiment of the present disclosure.
FIG. 2 is a schematic diagram of a second flow of a voltage filtering method for a detecting point in a circuit according to an embodiment of the present disclosure.
FIG. 3 is a schematic diagram of a third flow of a voltage filtering method for a detecting point in a circuit according to an embodiment of the present disclosure.
FIG. 4 is a schematic diagram of a fourth flow of a voltage filtering method for a detecting point in a circuit according to an embodiment of the present disclosure.
FIG. 5 is a schematic diagram of a first flow of a switch state detection method according to an embodiment of the present disclosure.
FIG. 6 is an example diagram of a control guidance unit according to an embodiment of the present disclosure.
FIG. 7 is a schematic diagram of a second flow of a switch state detection method according to an embodiment of the present disclosure.
FIG. 8 is a schematic diagram of a third flow of a switch state detection method according to an embodiment of the present disclosure.
FIG. 9 is a schematic diagram of a fourth flow of a switch state detection method according to an embodiment of the present disclosure.

FIG. 10 is a structural schematic diagram of a voltage filtering apparatus for a detecting point in a circuit according to an embodiment of the present disclosure.

FIG. 11 is a first structural schematic diagram of a switch state detection system according to an embodiment of the present disclosure.

FIG. 12 is a second structural schematic diagram of a switch state detection system according to an embodiment of the present disclosure.

FIG. 13 is a flow schematic diagram of the switch state detection method that is realized based on the switch state detection system according to an application example of the present disclosure.

FIG. 14 is a structural schematic diagram of an electronic device according to an embodiment of the present disclosure.

<u>DETAILED DESCRIPTION</u>

In order to more clearly illustrate purpose, technical solution and advantages of the embodiment of the present disclosure, hereinafter the technical solution in the embodiments of the present disclosure will be described clearly and integrally in combination with the accompanying drawings in the embodiments of the present disclosure, and obviously the described embodiments are merely part of the embodiments, not all of the embodiments. Any other embodiment obtained by those skilled in the art based on the embodiments of the present disclosure without paying any creative labor fall within the protection scope of the present disclosure.

It should be noted that the voltage filtering method for a detecting point in a circuit, the switch state detection method and apparatus disclosed in the present disclosure may be applied to the technical field of new energy, and may also be applied in any field other than the technical field of new energy. The method and related apparatus for voltage filtering for a detecting point in a circuit, and the switch state detection, and the system for the switch state detection, all of which are disclosed in the present disclosure may be applied in limitless field.

Considering that the existing voltage filtering method for a detecting point means using a single filtering circuit and etc. to filter the ripple in the voltage, this method cannot verify the effectiveness of voltage filtering, and thus cannot guarantee the accuracy of subsequent control or detection based on the filtered voltage. Embodiments of the present disclosure provide a method and an apparatus for voltage filtering method for a detecting point in a circuit, a method and an apparatus for switch state detection, all of which, by continuously collecting multiple voltage data of a detecting point in a target circuit; respectively obtaining a plurality of voltage filtering values corresponding to the detecting point by preforming filter modes based on the multiple voltage data; and comparing the plurality of voltage filtering values, and if the corresponding comparison result meets a preset condition, determining a voltage target value of the detecting point based on the plurality of voltage filtering values, so effectively verifies the validity of the voltage filtering for the detecting point in the circuit, effectively ensures the reliability of the voltage filtering for the detecting point, and effectively and reliably prevents the voltage jitter from causing the control misjudgment of the circuit, thereby effectively improving the accuracy and reliability of subsequent control or detection based on the filtered voltage. Especially for a control guidance unit and etc. of a charging base of new energy vehicles, the accuracy of detecting the switch state in the control guidance unit based on the filtered voltage is improved, thereby effectively improving the work stability and reliability of the control guidance unit of the charging base of new energy vehicles.

The details are illustrated by the following multiple embodiments.

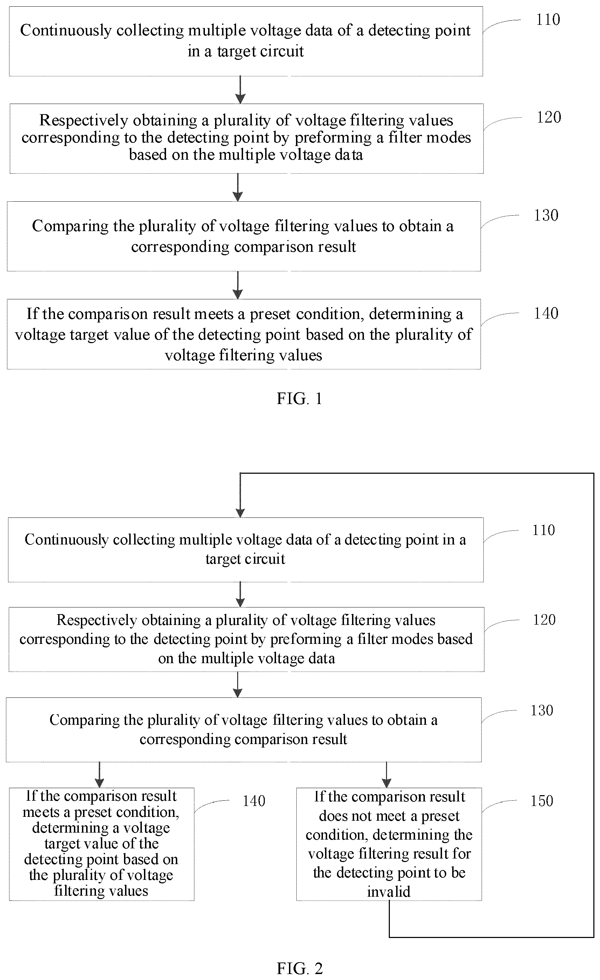

In order to solve the problems that the existing voltage filtering method for a detecting point cannot verify the effectiveness of voltage filtering, and thus cannot guarantee the accuracy of subsequent control or detection based on the filtered voltage, an embodiment of the present disclosure provides a voltage filtering method for a detecting point in a circuit, with reference to FIG. 1, the voltage filtering method for a detecting point in a circuit specifically includes:

A step 110 of continuously collecting multiple voltage data of a detecting point in a target circuit.

In the step 110, the continuous collection refers to collecting the data a preset number of times during a preset period, such as 10 times in 0.3 S, and then 10 voltage data $Vdp_1$ to $Vdp_{10}$ for a detecting point are obtained.

It can be understood that the voltage data refers to a digital signal, and the collection process of the digital signal is: collecting a voltage analog signal of a collection point in a target circuit; then converting the voltage analog signal to a digital signal to obtain a digital signal for filtering processing in the subsequent step 200.

In one or more embodiments of the present disclosure, the target circuits refer to all circuits, such as switching circuits and etc., in which detecting points are arranged and voltage filtering is performed on the detecting points. In an example of the present disclosure, the target circuit may refer specifically to a control guidance unit of a charging base of a new energy vehicle, and the control guidance unit may refer to a circuit for performing switching control and guidance on the charging base of the new energy vehicle.

A step 120 of respectively obtaining a plurality of voltage filtering values corresponding to the detecting point by preforming filter modes based on the multiple voltage data.

In the step 120, two or more filter modes may be selected to process the plurality of voltage data respectively to obtain the voltage filtering values corresponding to the detecting point, and the number of the voltage filtering values is equal to the number of selected filter modes. For example, if four filter modes A, B, C, and D are selected, the filtering results corresponding to the four filter modes are obtained, namely, the voltage filtering values A1, B1, C1, and D1. In an example, the filter modes may be selected as at least two of mean filter, median filter, post-interpolation filter, post-dimensionality-reduction filter and neighborhood average filter modes.

A step 130 of comparing the plurality of voltage filtering values to obtain a corresponding comparison result.

A step 140 of, if the comparison result meets a preset condition, determining a voltage target value of the detecting point based on the plurality of voltage filtering values.

In the steps 130 and 140, the manner of comparing the plurality of voltage filtering values may include obtaining a difference value between the maximum value and the minimum value of the plurality of voltage filtering values, and taking the difference value as a comparison result to determine whether the difference value is smaller than a threshold value such as a preset error threshold value, and if it is, determining the voltage target value of the detecting point based on the plurality of voltage filtering values.

It can be understood that the manner of determining the voltage target value of the detecting point based on the plurality of voltage filtering values may include: calculating a mean value of the plurality of voltage filtering values and determining the mean value as a voltage target value of the detecting point; or selecting a median value of the plurality of voltage filtering values, and determining the median value as the voltage target value of the detecting point; or selecting any one of the plurality of voltage filtering values as the voltage target value of the detecting point.

As can be seen from the above description, the voltage filtering method for a detecting point provided in the embodiment of the present disclosure effectively verifies the validity of the voltage filtering for the detecting point in the circuit, effectively ensures the reliability of the voltage filtering for the detecting point, and effectively and reliably prevents the voltage jitter from causing the control misjudgment of the circuit, thereby effectively improving the accuracy and reliability of subsequent control or detection based on the filtered voltage. Especially for a control guidance unit and etc. of a charging base of new energy vehicles, the accuracy of detecting the switch state in the control guidance unit based on the filtered voltage is improved, thereby effectively improving the work stability and reliability of the control guidance unit of the charging base of new energy vehicles.

In order to provide a reliable processing method when it is verified that the voltage filtering result for the detecting point are invalid or unreliable, in an embodiment of the voltage filtering method for a detecting point in a circuit provided by the present disclosure, with reference to FIG. 2, subsequent to the step 130, the voltage filtering method for a detecting point in a circuit may further include:

A step 150 of, if the comparison result does not meet a preset condition, determining the voltage filtering result for the detecting point to be invalid;

Then returning to the step 110 and executing the steps 110 to 130 again of: continuously collecting multiple voltage data of the detecting point again and obtaining a plurality of voltage filtering values corresponding to the detecting point until the comparison results obtained again meet the preset condition, and executing the step 140 of determining the voltage target value of the detecting point.

As can be seen from the above description, by the voltage filtering method for a detecting point provided in the embodiment of the present disclosure, a reliable processing method is provided when it is verified that the voltage filtering result for the detecting point in the circuit are invalid or unreliable, to further ensure the reliability of voltage filtering for the detecting point, thus the method effectively and reliably prevents the voltage jitter from causing the control misjudgment of the circuit, and effectively improves the widely applicable property of the voltage filtering process for the detecting point.

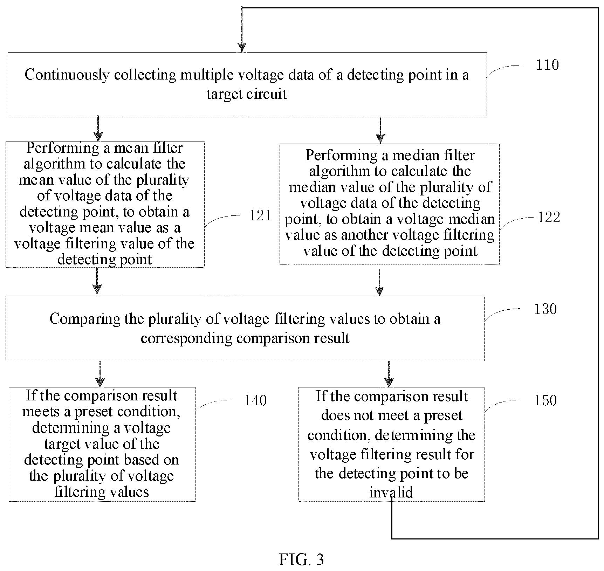

In order to reduce circuit complexity and reduce energy waste, in an embodiment of the voltage filtering method for a detecting point provided in this disclosure, with reference to FIG. 3, the step 120 of the voltage filtering method for a detecting point may specifically include:

A step 121 of performing a mean filter algorithm to calculate the mean value of the plurality of voltage data of the detecting point, to obtain a voltage mean value as a voltage filtering value of the detecting point.

For example, supposing that the detection point voltage is Vdp, taking n data of the detecting point, n is a positive integer; the sum of n data is Vdp_sum, then:

$$Vdp\_sum = Vdp_1 + Vdp_2 + Vdp_3 + \ldots\ldots + Vdp_{n-1} + Vdp_n;$$

supposing that the mean value of n data is Vdp_ave; then:

$$Vdp\_ave = Vdp\_sum/n.$$

A step 122 of performing a median filter algorithm to calculate the median value of the plurality of voltage data of the detecting point, to obtain a voltage median value as another voltage filtering value of the detecting point.

For example, supposing that the detection point voltage is Vdp, taking n data of the detecting point, and then operating as follows:

1. Firstly, the n voltage values of the detecting point are arranged in an ascending order or in a descending order, to obtain a data combination consisting of n voltage values that are rearranged;
2. Taking the value in the middle of the n data, i.e., the median value Vdp_mid;

If n is an even number, then:

$$Vdp\_mid=(Vdp_{n/2}+Vdp_{(n/2)+1})/2;$$

If n is an odd number, then:

$$Vdp\_mid=(Vdp_{(n/2)+1}).$$

As can be seen from the above description, in the voltage filtering method for a detecting point provided in the embodiment of the present disclosure, only two filter modes are selected to filter the plurality of voltage data of the detecting point, such that on the basis of ensuring the validity of the voltage filtering results, the calculation amount and time cost is reduced to the maximum extent, so as to be able to effectively reduce circuit complexity and reduce energy waste.

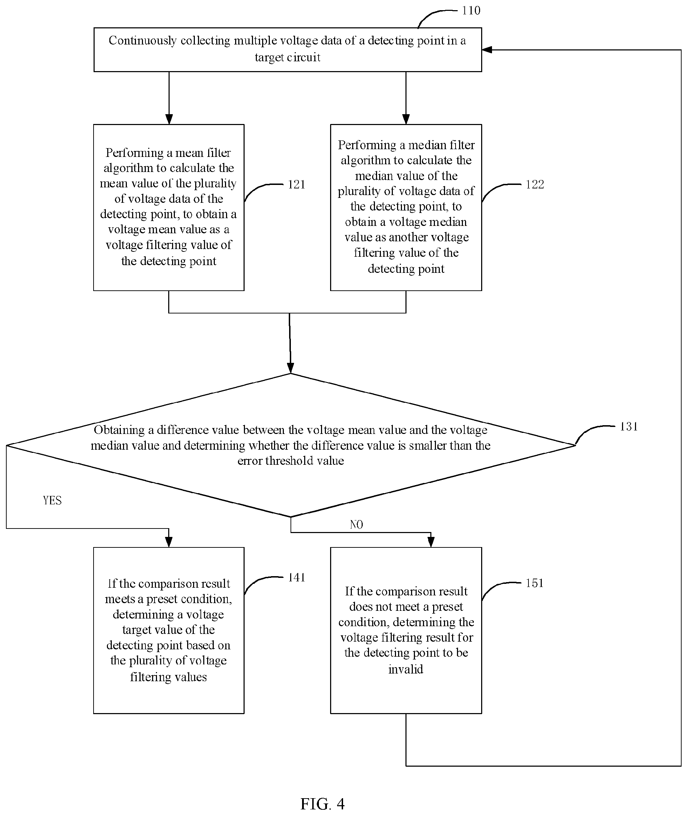

In order to further reduce circuit complexity and reduce energy waste, in an embodiment of the voltage filtering method for a detecting point provided in this disclosure, with reference to FIG. 4, the step 130 of the voltage filtering method for a detecting point may specifically include:

A step 131 of obtaining a difference value between the voltage mean value and the voltage median value and determining whether the difference value is smaller than the error threshold value, and if it is, executing the step 140 specifically including:

A step 141 of determining the voltage target value of the detecting point based on the voltage mean value and the voltage median value.

For example, after performing two filter algorithms provided in the steps 121 and 122, two values, Vdp_ave and Vdp_mid, are obtained, then subtraction is performed between the two values to obtain a difference value, and if the difference value is smaller than the error threshold value, determining the voltage target value of the detecting point based on the voltage mean value and the voltage median value; if the difference value is greater than or equal to the set error threshold value, returning to the step 110.

It can be understood that the manner of determining the voltage target value of the detecting point based on the voltage mean value and the voltage median value may include: calculating a mean value of the voltage mean value and the voltage median and determining the mean value as the voltage target value of the detecting point; or selecting any one of the voltage mean value and the voltage median value as the voltage target value of the detecting point.

As can be seen from the above description, in the voltage filtering method for a detecting point provided in the embodiment of the present disclosure, by determining the voltage target value of the detecting point based on the voltage mean value and the voltage median value, on the basis of ensuring the validity of the voltage filtering results, the calculation amount and time cost is further reduced, so as to be able to effectively reduce circuit complexity and reduce energy waste.

In order to solve the increasingly prominent energy crisis and environmental pollution problems, new energy vehicles have become the main direction of development in various countries. For a control guidance unit of a charging base of new energy vehicles, the effectiveness of detecting the switch state in the control guidance unit also determines the application reliability of the charging base of new energy vehicles. Accordingly, considering that a single filtering circuit and etc. are applied to the existing voltage filtering method for a detecting point to filter the ripple in the voltage, but this method cannot verify the effectiveness of voltage filtering, and thus cannot guarantee the accuracy of the switching state detection of the control guidance unit based on the filtered voltage, embodiments of the present disclosure provide a switch state detection method and switch state detecting apparatus which, based on the voltage filtering method for a detecting point mentioned in one or more of the above embodiments, obtains a voltage target value of a first detecting point after controlling a first switch to be closed, in which one end of the first switch is connected with a first resistor in the control guidance unit of a charging base, and the first detecting point is arranged at the other end of the first switch; determines whether the voltage target value of the first detecting point meets a first closing condition, and if so, determines that the first switch is currently in a closed state, thus effectively verifies the validity of the voltage filtering for the detecting point in the circuit, effectively ensures the reliability of the voltage filtering for the detecting point, effectively and reliably prevents the voltage jitter from causing the control misjudgment of the circuit, and is able to effectively improve the accuracy and reliability of the switch state detection in the control guidance unit of the charging base of new energy vehicles based on the filtered voltage, thereby effectively improving the work stability and reliability of the charging base of new energy vehicles.

The details are illustrated by the following multiple embodiments.

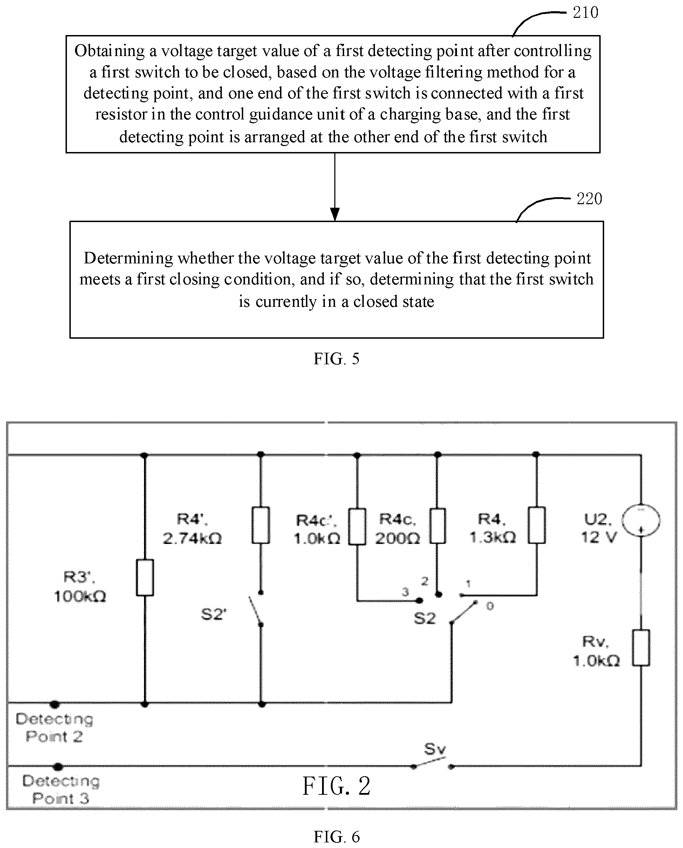

In order to solve that a single filtering circuit and etc. are applied to the existing voltage filtering method for a detecting point to filter the ripple in the voltage, but this method cannot verify the effectiveness of voltage filtering, and thus cannot guarantee the accuracy of the switching state detection of the control guidance unit based on the filtered voltage, in an embodiment of the switch state detection method provided in the present disclosure, with reference to FIG. 5, the switch state detection method specifically includes:

A step 210 of, obtaining a voltage target value of a first detecting point after controlling a first switch to be closed, based on a voltage filtering method for a detecting point, and one end of the first switch is connected with a first resistor in the control guidance unit of a charging base, and the first detecting point is arranged at the other end of the first switch.

It is understandable that the control guidance unit of the charging base is a specific implementation method of the target circuit. Therefore, in the step 210, the first detecting point is taken as the current detecting point in the voltage filtering method for a detecting point for filtering calculation., and for example, the steps 110 to 140 are applied to achieve the following:

Continuously collecting multiple voltage data of a first detecting point in the control guide unit of the charging base, respectively obtaining a plurality of voltage filtering values corresponding to the first detecting point by preforming a filter mode based on the multiple voltage data; comparing the plurality of voltage filtering values to obtain a corresponding comparison result, and if the comparison result satisfies the preset condition, determining a voltage target value Vdp3_last of the first detecting point based on the plurality of voltage filtering values.

In one or more embodiments of the present disclosure, the first detecting point is represented as DP3 and the first switch is represented as Sv.

A step 220 of determining whether the voltage target value of the first detecting point meets a first closing condition, and if so, determining that the first switch is currently in a closed state.

It can be understood that if it is determined in the step 220 that the voltage target value of the first detecting point does not meet a first closing condition, determining that the first switch fails to close and outputting an informing message indicating that the first switch fails to close. For example, the informing message may be displayed on the display that communicates with the switch state detection system, or the informing message is sent by a communication unit provided in the switch state detection system via a third-party server or itself to a client device held by the technician.

The client device held by the technician may include a smart phone, a tablet electronic device, a network set-top box, a portable computer, a desktop computer, a personal digital assistant (PDA), a vehicle-mounted device, a smart wearable device, etc. The smart wearable device may include smart glasses, a smart watch, a smart bracelet, etc. Thus, the efficiency of informing the message that the switch fails to close and the maintenance efficiency of the control guidance unit of the charging base by the technicians may be effectively improved.

The client device described above may have a communication module (that is, a communication unit), which communicates with a remote server to achieve data transmission with the server. The server may include a server on the side of the task scheduling center. In other implementation scenarios, a server of an intermediate platform may also be included, such as a server of a third-party server platform that communicates with the task scheduling center server. The server may include a single computer device, a server cluster composed of multiple servers, or a server structure of a distributed device.

Any suitable network protocol, including network protocols not yet developed at the filing date of the present disclosure, may be used to communicate between the server and the client device. The network protocol, for example, may include TCP/IP protocol, UDP/IP protocol, HTTP protocol, HTTPS protocol, etc. Of course, the network protocol may also include, for example, the Remote Procedure Call Protocol (RPC), the Representational State Transfer (REST) protocol, which are used over the above protocols, and etc.

As can be seen from the above description, the switch state detection method provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, and is able to effectively improve the accuracy and reliability of the switch state detection in the control guidance unit of the charging base of new energy vehicles based on the filtered voltage, thereby effectively improving the work stability and reliability of the charging base of new energy vehicles.

In order to further improve the application pertinence of the switch state detection method, in an embodiment of the switch state detection method of the present disclosure, the charging base is a compatible new energy vehicle charging base configured to compatibility with multiple charging protocols.

That is to say, the control guidance unit referred to in one or more embodiments of the present disclosure may be a control guidance unit specifically for a compatible new energy vehicle charging base compatible with multiple charging protocols.

It can be understood that in one specific example of the control guidance unit, with reference to FIG. 6, the control guidance unit may include: a first switch Sv, a first resistor Rv, a power supply U2, a second switch S2', a second resistor R4' and a selection switch S2. One end of the first switch Sv is connected with the first resistor Rv in the control guidance unit of the charging base of the compatible new energy vehicle, and the first detecting point DP3 (the Detecting Point 3 in FIG. 6) is arranged at the other end of the first switch Sv, the first resistor Rv is connected in series with the power supply U2 and forms a branch. One end of the second switch S2' is connected in series with the second resistor R4' in the control guidance unit to form a first branch, the first branch is connected in parallel with the branch where the first resistor Rv is located, and the first branch is also connected in parallel with the branch where the third resistor R3' is located. The control points 1 to 3 corresponding to the charging protocols corresponding to one end of the selection switch S2 are respectively connected with a resistor (i.e., a resistor R4c', a resistor R4c and a resistor R4), and the other end of the selection switch S2 is connected with the branch where the second detecting point DP2 (the Detecting Point 2 in FIG. 6) is located, and the branch where the second detecting point DP2 is located is also connected with the other end of the second switch S2'. The selection switch S2 is arranged on a second branch, and the second branch is respectively connected in parallel with the branch where the first resistor Rv is located and the first branch.

It can be understood that the first switch Sv is a connection state detection switch for detecting the connection state, the second switch S2' is a charge control switch for performing charge control, and the selection switch S2 is a protocol compatible switch for performing protocol compatibility.

In order to further improve the accuracy of the first switch state detection, in an embodiment of the switch state detection method of the present disclosure, the first closing condition of the switch state detection method specifically includes the following contents:

The voltage target value of the first detecting point obtained after the first switch is controlled to be closed is not equal to the voltage target value of the first detecting point obtained in advance before the first switch is controlled to be closed, and the voltage target value of the first detecting point obtained after the first switch is controlled to be closed is within the voltage range corresponding to either of the charging protocols.

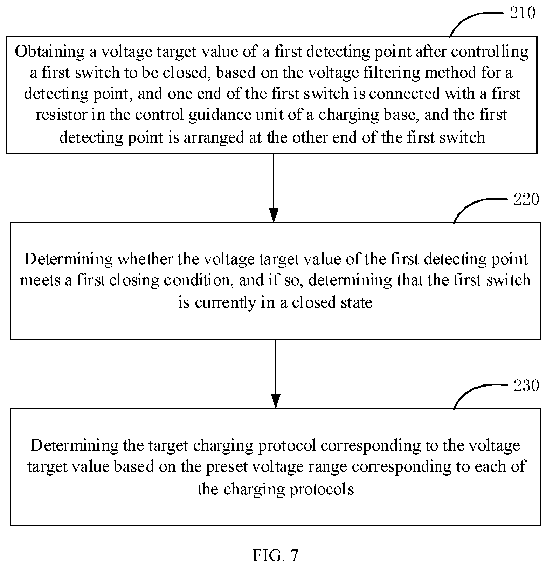

To provide a way to identify the charging protocol, in an embodiment of the switch state detection method of the present disclosure, with reference to FIG. 7, subsequent to the step 220, the switch state detection method further specifically includes:

A step 230 of determining a target charging protocol corresponding to the voltage target value based on the preset voltage range corresponding to each of the charging protocols.

From the above description, it can be seen that the switch state detection method provided by the embodiment of the present disclosure improves the reliability of closing the selection switch, meets the compatibility requirements of the compatible new energy vehicle charging base, and further improves the application reliability and stability of the compatible new energy vehicle charging base.

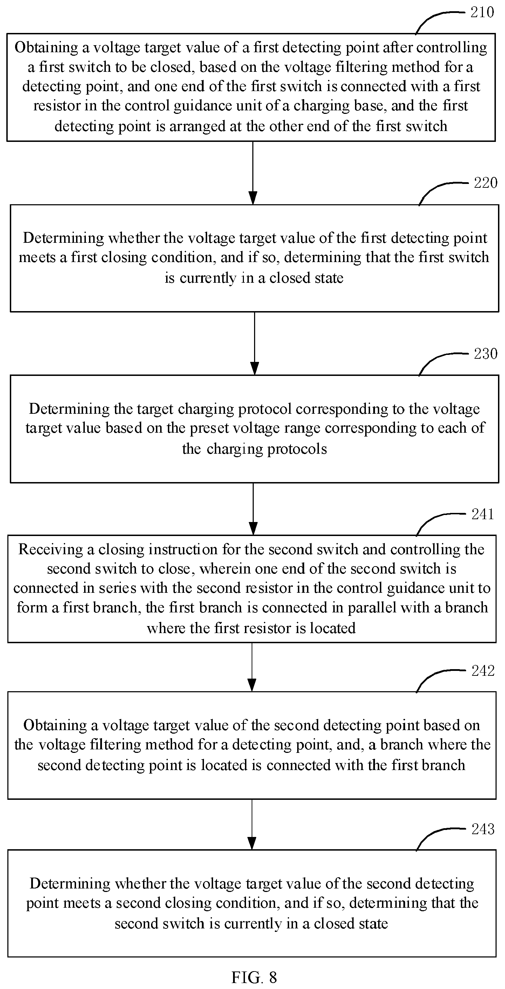

In order to improve the comprehensiveness and effectiveness of the switch state detection, in an embodiment of the switch state detection method of the present disclosure, with reference to FIG. 8, subsequent to the step 230, the switch state detection method further specifically includes:

A step 241 of receiving a closing instruction for the second switch and controlling the second switch to close, and one end of the second switch is connected in series with the second resistor in the control guidance unit to form a first branch, the first branch is connected in parallel with a branch where the first resistor is located;

A step 242 of obtaining a voltage target value of the second detecting point based on the voltage filtering method for a detecting point, and, a branch where the second detecting point is located is connected with the first branch; and

A step 243 of determining whether the voltage target value of the second detecting point meets a second closing condition, and if so, determining that the second switch is currently in a closed state.

In order to further improve the accuracy of the second switch state detection, in an embodiment of the switch state detection method of the present disclosure, the second closing condition of the switch state detection method specifically includes the following content:

the voltage target value of the second detecting point obtained after the second switch is controlled to be closed is not equal to the voltage target value of the second detecting point obtained in advance before the second switch is controlled to be closed.

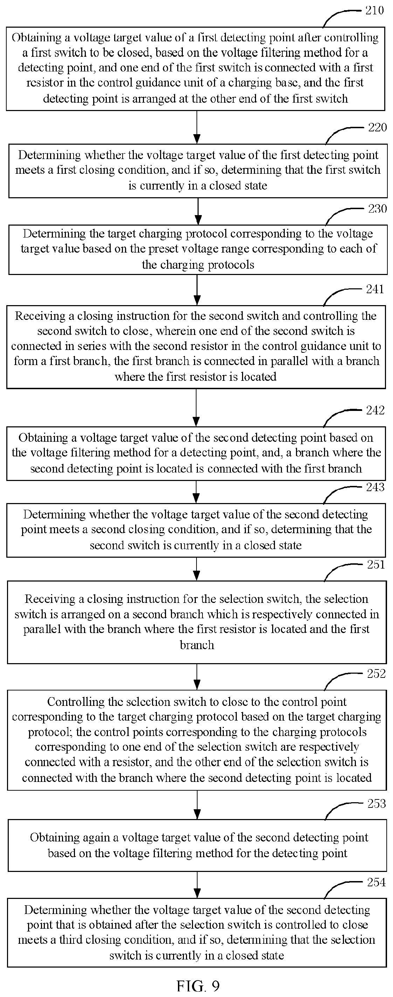

In order to improve the comprehensiveness and effectiveness of the selection switch state detection, in an embodiment of the switch state detection method of the present disclosure, with reference to FIG. 9, subsequent to the step 243, the switch state detection method further specifically includes:

A step 251 of receiving a closing instruction for a selection switch, and the selection switch is arranged on a second branch which is respectively connected in parallel with the branch where the first resistor is located and the first branch; and

A step 252 of controlling the selection switch to close to the control point corresponding to the target charging protocol based on the target charging protocol; and the control points corresponding to the charging protocols corresponding to one end of the selection switch are respectively connected with a resistor, and the other end of the selection switch is connected with the branch where the second detecting point is located;

A step 253 of obtaining again a voltage target value of the second detecting point based on the voltage filtering method for a detecting point; and

A step 254 of determining whether the voltage target value of the second detecting point that is obtained after the selection switch is controlled to close meets a third closing condition, and if so, determining that the selection switch is currently in a closed state.

From the above description, it can be seen that the switch state detection method provided by the embodiment of the present disclosure improves the reliability of closing the selection switch, meets the compatibility requirements of the compatible new energy vehicle charging base, and further improves the application reliability and stability of the compatible new energy vehicle charging base.

In order to further improve the accuracy of the selection switch state detection, in an embodiment of the switch state detection method of the present disclosure, the third closing condition of the switch state detection method specifically includes the following content:

the voltage target value of the second detecting point obtained after the selection switch is controlled to be closed is not equal to the voltage target value of the second detecting point obtained in advance before the selection switch is controlled to be closed.

On this basis, aiming at the ChaoJi charging system, which solves a series of defects and problems in the existing charging system and provide the world with a unified, safe, reliable and low-cost charging system solution, each of the charging protocols referred to in one or more embodiments of the present disclosure may include at least the ChaoJi charging standard, the GB (national standard of China) 2015 charging standard and the CHAdeMO (Charge de move: the fast-charging standard of electric vehicle in Japan) charging standard. That is to say, the compatible new energy vehicle charging base configured to compatibility with multiple charging protocols can be compatible with the ChaoJi charging standard, the GB 2015 charging standard and the CHAdeMO charging standard.

Based on this, in the switch state detection method, the voltage range corresponding to the ChaoJi charging standard is (5.64V, 6.36V).

The voltage range corresponding to the GB 2015 charging standard is (7.54V, 8.45V).

The voltage range corresponding to the CHAdeMO charging standard is (1.86V, 2.14V).

Then a specific example that the voltage target value of the first detecting point which is obtained after the first switch is controlled to close, referred to in the first closing condition, is within the voltage range corresponding to either of the charging protocols is as follows:

the voltage target value $Vdp_3$ of the first detecting point $DP3$ is in any range of $5.64V<Vdp_3<6.36V$ (ChaoJi), $7.54V<Vdp_3<8.45V$ (GB2015), $1.86V<Vdp_3<2.14V$ (CHAdeMO).

Correspondingly, the control point 1 corresponding to one end of the selection switch S2 in FIG. 6 is the control point corresponding to the CHAdeMO charging standard; the control point 3 is the control point corresponding to the GB 2015 charging standard; the control point 2 is the control point corresponding to the CHAdeMO charging standard.

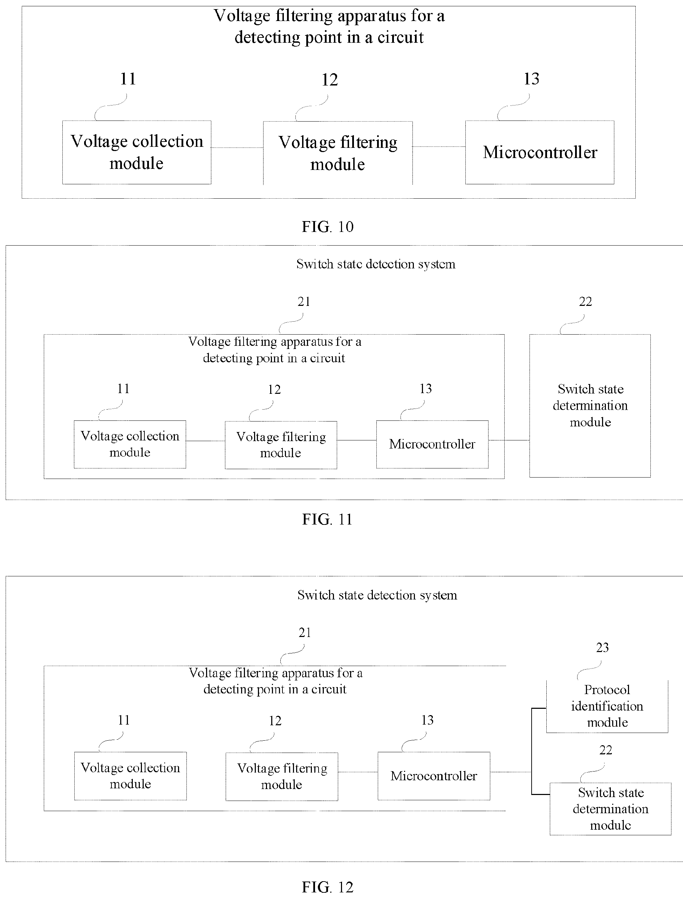

In order to solve the problems that the existing voltage filtering method for a detecting point cannot verify the effectiveness of voltage filtering, and thus cannot guarantee the accuracy of subsequent control or detection based on the filtered voltage, an embodiment of the present disclosure provides a voltage filtering apparatus for a detecting point in a circuit for realizing any or all of the contents of the voltage filtering method for a detecting point in a circuit, with reference to FIG. 10, the voltage filtering apparatus for a detecting point in a circuit specifically includes:

A voltage collection module 11 configured to continuously collect multiple voltage data of a detecting point in a target circuit.

In the voltage collection module 11, the continuous collection refers to collecting the data a preset number of times during a preset period, such as 10 times in 0.3 S, and then 10 voltage data $Vdp_1$ to $Vdp_{10}$ for a detecting point are obtained.

It can be understood that the voltage data refers to a digital signal, and the collection process of the digital signal is: collecting a voltage analog signal of a collection point in a target circuit; then converting the voltage analog signal to a digital signal to obtain a digital signal for subsequent filtering processing.

A voltage filtering module 12 configured to respectively obtain a plurality of voltage filtering values corresponding to the detecting point by preforming filter modes based on the multiple voltage data.

In the voltage filtering module 12, two or more filter modes may be selected to process the plurality of voltage data respectively to obtain the voltage filtering values corresponding to the detecting point, and the number of the voltage filtering values is equal to the selected filter modes. For example, if four filter modes A, B, C, and D are selected, the filtering results corresponding to the four filter modes are obtained, namely, the voltage filtering values A1, B1, C1, and D1. In a specific example, the filter modes may be selected as at least two of mean filter, median filter, post-interpolation filter, post-dimensionality-reduction filter and neighborhood average filter modes.

A microcontroller 13 configured to compare the plurality of voltage filtering values, and if the corresponding comparison result meets a preset condition, determine a voltage target value of the detecting point based on the plurality of voltage filtering values.

In the microcontroller 13, the manner of comparing the plurality of voltage filtering values may include obtaining a difference value between the maximum value and the minimum value of the plurality of voltage filtering values; and taking the difference value as a comparison result to determine whether the difference value is smaller than a threshold value such as a preset error threshold value; and if it is, determining the voltage target value of the detecting point based on the plurality of voltage filtering values.

It can be understood that the manner of determining the voltage target value of the detecting point based on the plurality of voltage filtering values may include: calculating a mean value of the plurality of voltage filtering values and determining the mean value as a voltage target value of the detecting point; or selecting a median value of the plurality of voltage filtering values, and determining the median value as the voltage target value of the detecting point; or selecting any one of the plurality of voltage filtering values as the voltage target value of the detecting point.

The embodiment of the voltage filtering apparatus for a detecting point in a circuit provided in the present disclosure may specifically be used to execute the processing flow of the embodiment of the voltage filtering method for a detecting point in the above embodiment, and the function thereof will not be repeated here and maybe found by referring to the detailed description of the above embodiment of the voltage filtering method for a detecting point.

As can be seen from the above description, the voltage filtering apparatus for a detecting point provided in the embodiment of the present disclosure effectively verifies the validity of the voltage filtering for the detecting point in the circuit, effectively ensures the reliability of the voltage filtering for the detecting point, and effectively and reliably prevents the voltage jitter from causing the control misjudgment of the circuit, thereby effectively improving the accuracy and reliability of subsequent control or detection based on the filtered voltage. Especially for a control guidance unit and etc. of a charging base of new energy vehicles, the accuracy of detecting the switch state in the control guidance unit based on the filtered voltage is improved, thereby effectively improving the work stability and reliability of the control guidance unit of the charging base of new energy vehicles.

In order to provide a reliable processing method when it is verified that the voltage filtering result for the detecting point are invalid or unreliable, in an embodiment of the voltage filtering apparatus for a detecting point provided by the present disclosure, the microcontroller 13 in the detection point voltage filter device is also configured to perform the following operation:

If the comparison result does not meet the preset condition, controlling the voltage collection module to continuously collect multiple voltage data of the detecting point again and controlling the voltage filtering module to obtain a plurality of voltage filtering values corresponding to the detecting point again, until a comparison result obtained by the microcontroller again meets the preset condition and the voltage target value of the detecting point is determined.

As can be seen from the above description, by the voltage filtering apparatus for a detecting point provided in the embodiment of the present disclosure, a reliable processing method is provided when it is verified that the voltage filtering result for the detecting point in the circuit are invalid or unreliable, to further ensure the reliability of voltage filtering for the detecting point, thus the method effectively and reliably prevents the voltage jitter from causing the control misjudgment of the circuit, and effectively improves the widely applicable property of the voltage filtering process for the detecting point.

In order to reduce circuit complexity and reduce energy waste, in an embodiment of the voltage filtering apparatus for a detecting point provided in this disclosure, the voltage filtering module 12 in the voltage filtering apparatus for a detecting point may specifically include:

A mean filter unit configured to perform a mean filter algorithm to calculate the mean value of the plurality of voltage data of the detecting point, to obtain a voltage mean value as a voltage filtering value of the detecting point; and

A median filter unit configured to perform a median filter algorithm to calculate the median value of the plurality of voltage data of the detecting point, to obtain a voltage median value as another voltage filtering value of the detecting point.

As can be seen from the above description, in the voltage filtering apparatus for a detecting point provided in the embodiment of the present disclosure, only two filter modes are selected to filter the plurality of voltage data of the detecting point, such that on the basis of ensuring the validity of the voltage filtering results, the calculation amount and time cost is reduced to the maximum extent, so as to be able to effectively reduce circuit complexity and reduce energy waste.

In order to further reduce circuit complexity and reduce energy waste, in an embodiment of the voltage filtering apparatus for a detecting point provided in this disclosure, the microcontroller 13 in the voltage filtering apparatus for a detecting point may specifically include:

An error determination unit configures to obtain a difference value between the voltage mean value and the voltage median value and determining whether the difference value is smaller than the error threshold value, and if it is, determine the voltage target value of the detecting point based on the voltage mean value and the voltage median value.

As can be seen from the above description, in the voltage filtering apparatus for a detecting point provided in the embodiment of the present disclosure, by determining the voltage target value of the detecting point based on the voltage mean value and the voltage median value, on the basis of ensuring the validity of the voltage filtering results, the calculation amount and time cost is further reduced, so as to be able to effectively reduce circuit complexity and reduce energy waste.

In order to solve that a single filtering circuit and etc. are applied to the existing voltage filtering method for a detecting point to filter the ripple in the voltage, but this method cannot verify the effectiveness of voltage filtering, and thus cannot guarantee the accuracy of the switching state detection of the control guidance unit based on the filtered voltage, the present disclosure provides an embodiment of a switch state detection system for implementing all or part of the switch state detection method, with reference to FIG. 11, the switch state detection system specifically includes:

A voltage filtering apparatus 21 for a detecting point configured to, obtain a voltage target value of a first detecting point after controlling a first switch to be closed, based on a voltage filtering method for a detecting point, and one end of the first switch is connected with a first resistor in the control guidance unit of a charging base, and the first detecting point is arranged at the other end of the first switch; and

A switch state determination module 22 configured to determine whether the voltage target value of the first detecting point meets a first closing condition, and if so, determine that the first switch is currently in a closed state.

It can be understood that if it is determined by the switch state determination module 22 that the voltage target value of the first detecting point does not meet a first closing condition, determining that the first switch fails to close and outputting an informing message indicating that the first switch fails to close. For example, the informing message may be displayed on the display that communicates with the switch state detection system, or the informing message is sent by a communication unit provided in the switch state detection system via a third-party server or itself to a client device held by the technician.

The embodiment of the switch state detection system provided in the present disclosure may specifically be used to execute the processing flow of the embodiment of the switch state detection method in the above embodiment, and the function thereof will not be repeated here and can be found by referring to the detailed description of the above embodiment of the switch state detection method.

As can be seen from the above description, the switch state detection system provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, and is able to effectively improve the accuracy and reliability of the switch state detection in the control guidance unit of the charging base of new energy vehicles based on the filtered voltage, thereby effectively improving the work stability and reliability of the charging base of new energy vehicles.

In order to further improve the application pertinence of the switch state detection method, in an embodiment of the switch state detection system of the present disclosure, the charging base is a compatible new energy vehicle charging base configured to compatibility with multiple charging protocols.

In order to further improve the accuracy of the first switch state detection, in an embodiment of the switch state detection system of the present disclosure, the first closing condition of the switch state detection system specifically includes the following contents:

The voltage target value of the first detecting point obtained after the first switch is controlled to be closed is not equal to the voltage target value of the first detecting point obtained in advance before the first switch is controlled to be closed, and the voltage target value of the first detecting point obtained after the first switch is controlled to be closed is within the voltage range corresponding to either of the charging protocols.

To provide a method to identify the charging protocol, in an embodiment of the switch state detection system of the present disclosure, with reference to FIG. 12, the switch state detection system further specifically includes:

A protocol identification module 23 configured to determine a target charging protocol corresponding to the voltage target value based on a preset voltage range corresponding to each of the charging protocols.

From the above description, it can be seen that the switch state detection system provided by the embodiment of the present disclosure improves the reliability of closing the selection switch, meets the compatibility requirements of the compatible new energy vehicle charging base, and further improves the application reliability and stability of the compatible new energy vehicle charging base.

In order to improve the comprehensiveness and effectiveness of the switch state detection, in an embodiment of the switch state detection system of the present disclosure, the voltage filtering apparatus for a detecting point in a circuit of the switch state detection system includes a voltage collection module 11, a voltage filtering module 12 and a microcontroller 13 that are connected in sequence.

The microcontroller 13 is further configured to receive a closing instruction for a second switch and control the second switch to close, and one end of the second switch is connected in series with the second resistor in the control guidance unit to form a first branch, the first branch is connected in parallel with the branch where the first resistor is located.

The voltage collection module 11, the voltage filtering module 12 and the microcontroller 13 that are connected in sequence are further configured to obtain a voltage target value of the second detecting point based on the voltage filtering method for a detecting point, and, the branch where the second detecting point is located is connected with the first branch.

The switch state determination module 22 is further configured to determine whether the voltage target value of the second detecting point meets a second closing condition, and if so, determine that the second switch is currently in a closed state.

In order to further improve the accuracy of the second switch state detection, in an embodiment of the switch state detection system of the present disclosure, the second closing condition of the switch state detection method specifically includes the following content:

The voltage target value of the second detecting point obtained after the second switch is controlled to be closed is not equal to the voltage target value of the second detecting point obtained in advance before the second switch is controlled to be closed.

In order to improve the comprehensiveness and effectiveness of the selection switch state detection, in an embodiment of the switch state detection system of the present disclosure, the microcontroller 13 in the switch state detection system is further configured to receive a closing instruction for the selection switch, and the selection switch is arranged on a second branch, and the second branch is respectively connected in parallel with the branch where the first resistor is located and the first branch; and

Control the selection switch to close to the control point corresponding to the target charging protocol based on the target charging protocol; and the control points corresponding to the charging protocols corresponding to one end of the selection switch are respectively connected with a resistor, and the other end of the selection switch is connected with the branch where the second detecting point is located.

The voltage collection module 11, the voltage filtering module 12 and the microcontroller 13 that are connected in sequence are further configured to obtain again the voltage target value of the second detecting point based on the voltage filtering method for a detecting point.

The switch state determination module 22 is further configured to determine whether the voltage target value of the second detecting point that is obtained after the selection switch is controlled to close meets a third closing condition, and if so, determine that the selection switch is currently in a closed state.

From the above description, it can be seen that the switch state detection system provided by the embodiment of the present disclosure improves the reliability of closing the selection switch, meets the compatibility requirements of the compatible new energy vehicle charging base, and further improves the application reliability and stability of the compatible new energy vehicle charging base.

In order to further improve the accuracy of the selection switch state detection, in an embodiment of the switch state detection system of the present disclosure, the third closing condition of the switch state detection system specifically includes the following contents:

The voltage target value of the second detecting point obtained after the selection switch is controlled to be closed is not equal to the voltage target value of the second detecting point obtained in advance before the selection switch is controlled to be closed.

On this basis, each of the charging protocols may include at least the ChaoJi charging standard, the GB 2015 charging standard and the CHAdeMO (Charge de move: the fast-charging standard of electric vehicle in Japan) charging standard. That is to say, the compatible new energy vehicle charging base configured to compatibility with multiple charging protocols can be compatible with the ChaoJi charging standard, the GB 2015 charging standard and the CHAdeMO charging standard.

Based on this, in the switch state detection system, the voltage range corresponding to the ChaoJi charging standard is (5.64V, 6.36V).

The voltage range corresponding to the GB 2015 charging standard is (7.54V, 8.45V).

The voltage range corresponding to the CHAdeMO charging standard is (1.86V, 2.14V).

In order to further illustrate the technical solution, the present disclosure further provides a specific application example of implementing the switch state detection method by using the switch state detection system, for a charging base compatible with ChaoJi (ChaoJi super charging standard), GB 2015, CHAdeMO (Charge de move: the fast-charging standard of electric vehicle in Japan), in order to reduce circuit complexity and reduce energy waste, the application example of the present disclosure provides a logical algorithm to determine the switch state based on voltage of the detecting point (DP (including DP2\DP3)). Specific functions are as follows:

Referring to FIG. 12, the switch state detection system includes a voltage collection module 11, a voltage filtering module 12, a switch state determination module 22, a protocol identification module 23 and a microcontroller 13, which are described specifically as below:

(1) The voltage collection module 11 is configured to collect the voltage of the DP, and convert the voltage analog signal of the DP to a digital signal.

(2) The voltage filtering module 12 configured to filter the obtained digital signal of the obtained DP voltage to prevent the system from misjudgment caused by voltage jitter.

(3) The switch state determination module 22 configured to determine the switch state (open (turn off) or close (turn on)) based on the change of DP2 point voltage.

(4) The protocol identification module 23 configured to determine the voltage of the DP3 point by the microcontroller, identify the current state as the ChaoJi standard when the DP3 voltage is higher than 5.64 and lower than 6.36; identify the current state as the (GB 2015) standard when the DP3 voltage is higher than 7.54 and lower than 8.45; and identify the current state as the CHAdeMO standard when the DP3 voltage is higher than 1.86 and lower than 2.14.

(5) The microcontroller 13 configured to obtain the voltage value via the DP point input to the voltage filtering algorithm module, obtain the true value of the DP point voltage, and perform logical operations to determine the state of the switch.

On the basis of FIG. 12, the switch state detection system may further include a switch control unit that controls the open and close of the switch by the microcontroller 13.

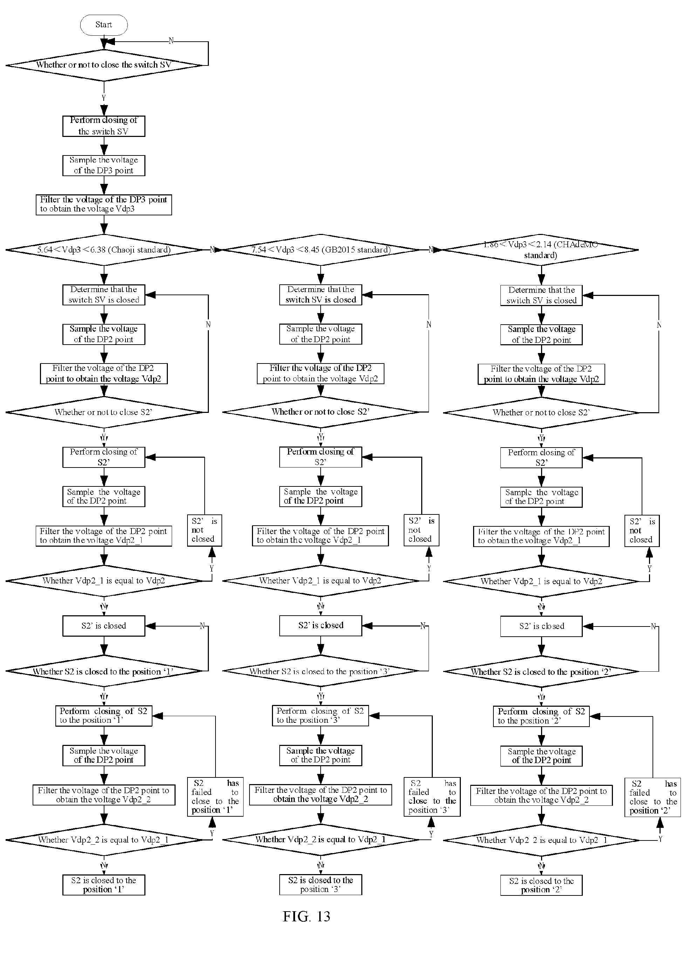

Based on the switch state detection system described above, the application example of the present disclosure further provides a switch state detection method that is implemented based on the switch state detection system, with reference to FIG. 13, specifically including:

S1: waiting for the CCU (on-board charge controller) to send a closing Sv command after the device is powered on. The CCU sends the closing command, the microcontroller unit controls the Sv to close, and the switch control unit performs Sv closing.

S2: measuring the voltage value of the DP3 point and filtering the DP3 voltage to obtain a stable voltage value; the microcontroller controls to read the current Vdp3_last voltage that is recorded before the Sv is closed, and the microcontroller reads the voltage is Vdp3 when the Sv is controlled to be closed, for example, if Vdp3_last is equal to Vdp3 or is not within in the range of 5.64V<Vdp3<6.36V (Chaoji), 7.54V<Vdp3<8.45V (GB2015), 1.86V<Vdp3<2.14V (CHAdeMO), it is determined that Sv has failed to close and Sv is open.

S3: if the DP3 voltage value is within the above range, it is determined that Sv has succeeded to close, and the current standard to be performed are determined based on the voltage value as described above.

S4: when the standard is determined, waiting for the CCU to send a closing command for S2', CCU sends a command to close S2', measures the DP2 voltage, filters and records the current DP2 voltage value.

The microcontroller controls S2' to be closed, the switch controller performs closing of S2', and thereafter measures the DP2 voltage and performs filtering. If the DP2 voltage after S2' is controlled to be closed is not equal to that before S2' is controlled to be closed, it is determined that S2' is closed; otherwise, it is determined that S2' has failed to be closed.

S5: after S2' is closed, waiting for a command to close S2 from CCU, CCU sends a command to close S2, measures the DP2 voltage and performs filtering; the microcontroller controls the position where S2 is closed based on different protocols, the microcontroller controls to close S2, and the switch controller performing closing of S2. The DP2 voltage is measured and filtering is performed. If the DP2 voltage after S2 is controlled to be closed is not equal to that before S2 is controlled to be closed, it is determined that S2 is closed; otherwise, it is determined that S2 has failed to be closed.

And, filter algorithm involved in S2 is as follows:

In order to ensure the accuracy of the data, two different filter algorithms are used, and then the output values thereof are compared. If the difference value between the values outputted by the two methods is smaller than the set error threshold value, it is determined that the data is correct this time.

(1) Mean algorithm

Assuming that the voltage of DP point (DP2, DP3) is Vdp, taking n data of DP point, and the sum of n data is Vdp_sum, the average value of n data is Vdp_ave

$$Vdp\_sum = Vdp_1 + Vdp_2 + Vdp_3 + \ldots\ldots + Vdp_{n-1} + Vdp_n \quad Vdp\_ave = Vdp\_sum/n;$$

(2) Median filter algorithm

Assuming that the voltage of DP point (DP2, DP3) is Vdp, and taking n data of DP point.

1. Firstly, the n voltage values of the DP point are arranged in an ascending order or in a descending order, to obtain a new combination of n data;
2. Taking the middle value of N data;
3. The median value is Vdp mid:

If N is an even number, then $Vdp\_mid = (Vdp_{n/2} + Vdp_{(n/2)+1})/2$

If N is an odd number, then $Vdp\_mid = (Vdp_{(n/2)+1})$

After performing two filter algorithms, two values, Vdp_ave and Vdp_mid, are obtained, and then subtraction is performed between the two values; if the difference value is greater than the set threshold value, the data is determined to be incorrect and the set of data is discarded, and the microcontroller re-obtains n data from the filtering module for the above algorithm. Re-collection is to collect a set of n data of the DP points and perform filtering calculation; if the data is wrong, a set of new n data is re-collected.

In terms of hardware, in order to solve that the existing voltage filtering method for a detecting point cannot verify the effectiveness of voltage filtering, and thus cannot guarantee the accuracy of subsequent control or detection based on the filtered voltage, the present disclosure provides an embodiment of an electronic device for implementing all or part of the voltage filtering method for a detecting point in a circuit or the switch state detection method, and the electronic device specifically includes the following:

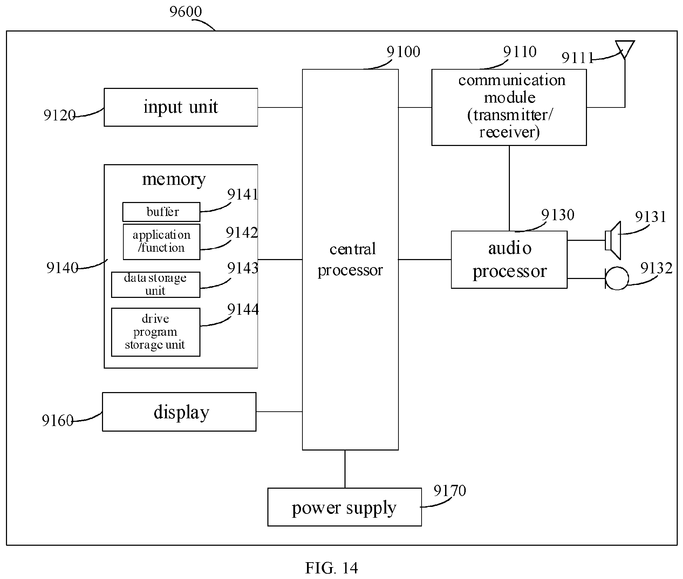

FIG. 14 is a schematic block diagram of system configuration of an electronic device 9600 according to an embodiment of the present disclosure. As shown in FIG. 14, the electronic device 9600 may include a central processor 9100 and a memory 9140; the memory 9140 is coupled to the central processor 9100. It is worth noting that FIG. 14 is exemplary; other types of structures may also be used in addition to or instead of the structure to implement telecommunications functions or other functions.

In an embodiment, the voltage filtering function for a detecting point in a circuit may be integrated into the central processor. The central processor may be configured to perform the following control of:

A step 110 of continuously collecting multiple voltage data of a detecting point in a target circuit;
A step 120 of respectively obtaining a plurality of voltage filtering values corresponding to the detecting point by preforming filter modes based on the multiple voltage data;
A step 130 of comparing the plurality of voltage filtering values to obtain a corresponding comparison result; and
A step 140 of, if the comparison result meets a preset condition, determining a voltage target value of the detecting point based on the plurality of voltage filtering values.

As can be seen from the above description, the electronic device for implementing the voltage filtering method for a detecting point in a circuit provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, thereby effectively improving the accuracy and reliability of subsequent control or detection based on the filtered voltage. Especially for a control guidance unit and etc. of a charging base of new energy vehicles, the accuracy of detecting the switch state in the control guidance unit based on the filtered voltage is improved, thereby effectively improving the work stability and reliability of the control guidance unit of the charging base of new energy vehicles.

Alternatively, in another embodiment, the switch state detection function may be integrated into the central processor. The central processor may be configured to perform the following control of:

A step 210 of, obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch; and
A step 220 of determining whether the voltage target value of the first detecting point meets a first closing condition, and if so, determining that the first switch is currently in a closed state.

As can be seen from the above description, the electronic device for implementing the switch state detection method provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, and is able to effectively improve the accuracy and reliability of the switch state detection in the control guidance unit of the charging base of new energy vehicles based on the filtered voltage, thereby effectively improving the work stability and reliability of the charging base of new energy vehicles.

In another embodiment, the voltage filtering apparatus for a detecting point in a circuit or the switch state detection apparatus may be configured separately from the central processor 9100. For example, the voltage filtering apparatus for a detecting point in a circuit or the switch state detection apparatus may be configured as a chip connected to the central processor 9100, and the voltage filtering function for a detecting point in a circuit or the switch state detection function may be implemented by the control of the central processor.

As shown in FIG. 14, the electronic device 9600 may further include a communication module 9110, an input unit 9120, an audio processor 9130, a display 9160, and a power supply 9170. It is worth noting that the electronic device 9600 is not necessarily required to include all of the components shown in FIG. 14; in addition, the electronic device 9600 may further include components not shown in FIG. 14, with reference to the prior art.

As shown in FIG. 14, the central processor 9100, sometimes referred to as a controller or an operational control, may include a microprocessor or other processor apparatuses and/or logic apparatuses, the central processor 9100 receives inputs and controls operation of the components of the electronic device 9600.

Where, the memory 9140 may be, for example, one or more of a buffer, a flash memory, a hard drive, a removable media, a volatile memory, a non-volatile memory, or other suitable apparatuses. The above-described failure-related information may be stored, and in addition, a program for executing the relevant information may be stored. And the central processor 9100 may execute the program stored in the memory 9140 to implement information storage or processing and the like.

The input unit 9120 provides an input to the central processor 9100. The input unit 9120 is, for example, a key or a touch input apparatus. The power supply 9170 is configured to provide electric power to the electronic device 9600. The display 9160 is configured to display objects to be displayed, such as images and text, and the like. The display may be, for example, an LCD display, but is not limited thereto.

The memory 9140 may be a solid-state memory such as read only memory (ROM), random access memory (RAM), SIM card, or the like. The memory may also be such a memory that it saves information even when power is off, on which data can be selectively erased and more data is set, and an example of which is sometimes referred to as an EPROM or the like. The memory 9140 may also be some other types of apparatuses. The memory 9140 includes a buffer memory 9141 (sometimes referred to as a buffer). The memory 9140 may include an application/function storage unit 9142 configured to store a flow for performing operation of an electronic device 9600 by the central processor 9100, or application programs and function programs.

The memory 9140 may also include a data storage unit 9143 for storing data, such as contacts, digital data, pictures, sounds, and/or any other data used by the electronic device. A drive program storage unit 9144 of the memory 9140 may include various drive programs of the electronic device for communication functions and/or for executing other functions of the electronic device, such as a messaging application, an address book application, and the like.

The communication module 9110 is a transmitter/receiver 9110 that transmits and receives signals via an antenna 9111. The communication module (transmitter/receiver) 9110 is coupled to the central processor 9100 to provide input signals and to receive output signals, which may be the same as in the case of conventional mobile communication terminals.

Based on different communication technologies, a plurality of communication modules 9110, such as a cellular network module, a Bluetooth module, and/or a wireless local area network module and the like may be provided in the same electronic device. The communication module (transmitter/receiver) 9110 is also coupled to a speaker 9131 and a microphone 9132 via an audio processor 9130 to provide an audio output via the speaker 9131, and to receive an audio input from the microphone 9132, thereby implementing the usual telecommunications functions. The audio processor 9130 may include any suitable buffer, decoder, amplifier, or the like. In addition, the audio processor 9130 is also coupled to the central processor 9100 so that sound can be recorded on the local machine by the microphone 9132, and the sound stored on the local machine can be played by the speaker 9131.

The embodiment of the present disclosure further provides a computer-readable storage media capable of implementing all steps of the voltage filtering method for a detecting point in a circuit or the switch state detection method in the above embodiments, the computer-readable storage media stores a computer program which, when being executed by a processor, implements all steps of the voltage filtering method for a detecting point in a circuit or the switch state detection method in the above embodiments, and for example, the processor executes the computer program to implement the following steps:

A step 110 of continuously collecting multiple voltage data of a detecting point in a target circuit;
A step 120 of respectively obtaining a plurality of voltage filtering values corresponding to the detecting point by preforming filter modes based on the multiple voltage data;
A step 130 of comparing the plurality of voltage filtering values to obtain a corresponding comparison result; and
A step 140 of, if the comparison result meets a preset condition, determining a voltage target value of the detecting point based on the plurality of voltage filtering values.

As can be seen from the above description, the computer-readable storage media for implementing the voltage filtering method for a detecting point in a circuit provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, thereby effectively improving the accuracy and reliability of subsequent control or detection based on the filtered voltage. Especially for a control guidance unit and etc. of a charging base of new energy vehicles, the accuracy of detecting the switch state in the control guidance unit based on the filtered voltage is improved, thereby effectively improving the work stability and reliability of the control guidance unit of the charging base of new energy vehicles.

Alternatively, the processor executes the computer program to implement the following steps:

A step 210 of, obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch; and

A step 220 of determining whether the voltage target value of the first detecting point meets a first closing condition, and if so, determining that the first switch is currently in a closed state.

As can be seen from the above description, the computer-readable storage media for implementing the switch state detection method provided in the embodiment of the present disclosure effectively verifies the validity of the voltage filtering for the detecting point in the circuit, effectively ensures the reliability of the voltage filtering for the detecting point, effectively and reliably prevents the voltage jitter from causing the control misjudgment of the circuit, and is able to effectively improve the accuracy and reliability of the switch state detection in the control guidance unit of the charging base of new energy vehicles based on the filtered voltage, thereby effectively improving the work stability and reliability of the charging base of new energy vehicles.

Persons skilled in the art shall understand that, the embodiments of the present invention may be provided as a method, an apparatus or a computer program product. Therefore, the present invention may be configured with the forms of a full hardware example, a full software example, or combination of a software example and a hardware example. Moreover, the present invention may be configured with the form of a computer program product that is implemented on one or more computer-usable storage media (including but not limited to a disk memory, a CD-ROM, an optical memory, and etc.) including computer-usable program codes. The invention is described with reference to flow diagrams and/or block diagrams of the method, the device (apparatus) and the computer program product based on the embodiment of the invention. It should be understood that each flow and/or block in the flow diagrams and/or block diagrams, and the combination of the flows and/or blocks in the flow diagrams and/or block diagrams may be achieved by computer program commands. These computer program commands may be provided to a CPU of a general-purpose computer, a special-purpose computer, an embedded processor or other programmable data processing device to produce a machine, so that a device for achieving functions designated in one or more flows in the flow diagrams and/or one or more blocks in the block diagrams may be generated by the command executed by the CPU of the computer or other programmable data processing device. These computer program instructions may also be stored in a computer-readable memory that guides a computer or other programmable data processing device to operate in a special way, so that the instruction stored in the computer-readable memory generates a manufactured product including an instruction device which achieves functions designated in one or more flows in the flow diagrams and/or one or more blocks in the block diagrams.

These computer program instructions may also be loaded on a computer or other programmable data processing device, on which a series of operation steps are executed to generate processing achieved by the computer, so that the instruction executed on the computer or other programmable data processing device is provided for being used in the steps of achieving functions designated in one or more flows in the flow diagrams and/or one or more blocks in the block diagrams.

**Claims**

1. A voltage filtering method for a detecting point in a circuit, comprising:

   continuously collecting multiple voltage data of a detecting point in a target circuit;
   respectively obtaining a plurality of voltage filtering values corresponding to the detecting point by preforming filter modes based on the multiple voltage data; and
   comparing the plurality of voltage filtering values, and if the corresponding comparison result meets a preset condition, determining a voltage target value of the detecting point based on the plurality of voltage filtering values,
   **characterized in that** the respectively obtaining the plurality of voltage filtering values corresponding to the detecting point by applying the filter modes based on the multiple voltage data comprises:

   performing a mean filter algorithm to calculate the mean value of the plurality of voltage data of the detecting point, to obtain a voltage mean value as a voltage filtering value of the detecting point; and
   performing a median filter algorithm to calculate the median value of the plurality of voltage data of the detecting point, to obtain a voltage median value as another voltage filtering value of the detecting point;
   wherein the comparing the plurality of voltage filtering values, and if the corresponding comparison result meets the preset condition, determining the voltage target value of the detecting point based on the plurality of voltage filtering values comprises:

obtaining a difference value between the voltage mean value and the voltage median value and determining whether the difference value is smaller than the error threshold value, and if it is, determining the voltage target value of the detecting point based on the voltage mean value and the voltage median value.

2. The voltage filtering method for a detecting point according to claim 1, further comprising:
if the comparison result does not meet the preset condition, continuously collecting multiple voltage data of the detecting point again and obtaining a plurality of voltage filtering values corresponding to the detecting point again, until a comparison result obtained again meets the preset condition and the voltage target value of the detecting point is determined.

3. A switch state detection method, comprising:

obtaining a voltage target value of a first detecting point (DP3) after controlling a first switch (Sv) to be closed, based on a voltage filtering method for a detecting point according to any one of claims 1 to 2, wherein, one end of the first switch (Sv) is connected with a first resistor (Rv) in the control guidance unit of a charging base, and the first detecting point (DP3) is arranged at the other end of the first switch (Sv); and
determining whether the voltage target value of the first detecting point (DP3) meets a first closing condition, and if so, determining that the first switch (Sv) is currently in a closed state.

4. The switch state detection method according to claim 3, wherein, the charging base is a compatible new energy vehicle charging base configured to compatibility with multiple charging protocols.

5. The switch state detection method according to claim 4, wherein, the first closing condition comprises:

the voltage target value of the first detecting point (DP3) obtained after the first switch (Sv) is controlled to be closed is not equal to the voltage target value of the first detecting point (DP3) obtained in advance before the first switch (Sv) is controlled to be closed, and the voltage target value of the first detecting point (DP3) obtained after the first switch (Sv) is controlled to be closed is within the voltage range corresponding to either of the charging protocols; or
wherein, after the determining that the first switch (Sv) is currently in the closed state, the switch state detection method further comprises:
determining a target charging protocol corresponding to the voltage target value based on a preset voltage range corresponding to each of the charging protocols.

6. The switch state detection method according to claim 4, wherein, after the determining that the first switch (Sv) is currently in the closed state, the switch state detection method further comprises:

determining a target charging protocol corresponding to the voltage target value based on a preset voltage range corresponding to each of the charging protocols, and
after the determining the target charging protocol corresponding to the voltage target value, the switch state detection method further comprises:

receiving a closing instruction for the second switch (S2') and controlling the second switch (S2') to close, wherein one end of the second switch (S2') is connected in series with the second resistor (R4') in the control guidance unit to form a first branch, the first branch is connected in parallel with a branch where the first resistor (Rv) is located;
obtaining a voltage target value of the second detecting point (DP2) based on the voltage filtering method for a detecting point, wherein, a branch where the second detecting point (DP2) is located is connected with the first branch;
determining whether the voltage target value of the second detecting point (DP2) meets a second closing condition, and if so, determining that the second switch (S2') is currently in a closed state.

7. The switch state detection method according to claim 6, wherein, the second closing condition comprises:
the voltage target value of the second detecting point (DP2) obtained after the second switch (S2') is controlled to be closed is not equal to the voltage target value of the second detecting point (DP2) obtained in advance before the second switch (S2') is controlled to be closed.

8. The switch state detection method according to claim 6, wherein, after the determining that the second switch (S2') is currently in a closed state, the switch state detection method further comprises:

receiving a closing instruction for a selection switch (S2), wherein the selection switch (S2) is arranged on a second branch which is respectively connected in parallel with the branch where the first resistor (Rv) is located and the first branch;

controlling the selection switch (S2) to close to the control point corresponding to the target charging protocol based on the target charging protocol; wherein the control points corresponding to the charging protocols corresponding to one end of the selection switch (S2) are respectively connected with a resistor, and the other end of the selection switch (S2) is connected with the branch where the second detecting point (DP2) is located;

obtaining again a voltage target value of the second detecting point (DP2) based on the voltage filtering method for the detecting point;

determining whether the voltage target value of the second detecting point (DP2) that is obtained after the selection switch (S2) is controlled to close meets a third closing condition, and if so, determining that the selection switch (S2) is currently in a closed state;

preferably wherein

the third closing condition comprises:

the voltage target value of the second detecting point (DP2) obtained after the selection switch (S2) is controlled to be closed is not equal to the voltage target value of the second detecting point (DP2) obtained in advance before the selection switch (S2) is controlled to be closed.

9. A voltage filtering apparatus for a detecting point in a circuit, comprising:

a voltage collection module (11) configured to continuously collect multiple voltage data of a detecting point in a target circuit;

a voltage filtering module (12) configured to respectively obtain a plurality of voltage filtering values corresponding to the detecting point by preforming filter modes based on the multiple voltage data; and

a microcontroller (13) configured to compare the plurality of voltage filtering values, and if the corresponding comparison result meets a preset condition, determine a voltage target value of the detecting point based on the plurality of voltage filtering values,

**characterized in that** the voltage filtering module (12) comprises:

a mean filter unit configured to perform a mean filter algorithm to calculate the mean value of the plurality of voltage data of the detecting point, to obtain a voltage mean value as a voltage filtering value of the detecting point; and

a median filter unit configured to perform a median filter algorithm to calculate the median value of the plurality of voltage data of the detecting point, to obtain a voltage median value as another voltage filtering value of the detecting point;

wherein the microcontroller (13) comprises:

an error determination unit configured to obtain a difference value between the voltage mean value and the voltage median value and determining whether the difference value is smaller than the error threshold value, and if it is, determine the voltage target value of the detecting point based on the voltage mean value and the voltage median value.

10. The voltage filtering apparatus for a detecting point according to claim 9, wherein, the microcontroller (13) is further configured to perform the following operation:

if the comparison result does not meet the preset condition, controlling the voltage collection module (11) to continuously collect multiple voltage data of the detecting point again and controlling the voltage filtering module (12) to obtain a plurality of voltage filtering values corresponding to the detecting point again, until a comparison result obtained by the microcontroller (13) again meets the preset condition and the voltage target value of the detecting point is determined.

11. A switch state detection system, comprising:

a voltage filtering apparatus for a detecting point configured to, obtain a voltage target value of a first detecting point (DP3) after controlling a first switch (Sv) to be closed, based on a voltage filtering method for a detecting point according to any one of claims 1 to 2, wherein, one end of the first switch (Sv) is connected with a first resistor (Rv) in the control guidance unit of a charging base, and the first detecting point (DP3) is arranged at the other end of the first switch (Sv); and

a switch state determination module (22) configured to determine whether the voltage target value of the first detecting point (DP3) meets a first closing condition, and if so, determine that the first switch (Sv) is currently in a closed state.

12. The switch state detection system according to claim 11, wherein, the charging base is a compatible new energy vehicle charging base configured to compatibility with multiple charging protocols;

preferably wherein
further comprising: a protocol identification module (23) configured to determine a target charging protocol corresponding to the voltage target value based on a preset voltage range corresponding to each of the charging protocols,
preferably wherein
the voltage filtering apparatus for a detecting point in a circuit comprises a voltage collection module (11), a voltage filtering module (12) and a microcontroller (13) that are connected in sequence;
the microcontroller (13) is further configured to receive a closing instruction for the second switch (S2') and control the second switch (S2') to close, wherein one end of the second switch (S2') is connected in series with the second resistor (R4') in the control guidance unit to form a first branch, the first branch is connected in parallel with the branch where the first resistor (Rv) is located;
the voltage collection module (11), the voltage filtering module (12) and the microcontroller (13) that are connected in sequence are further configured to obtain a voltage target value of the second detecting point (DP2) based on the voltage filtering method for a detecting point, wherein, the branch where the second detecting point (DP2) is located is connected with the first branch;
the switch state determination module (22) is further configured to determine whether the voltage target value of the second detecting point (DP2) meets a second closing condition, and if so, determine that the second switch (S2') is currently in a closed state,
preferably wherein
the microcontroller (13) is further configured to receive a closing instruction for a selection switch (S2), wherein the selection switch (S2) is arranged on a second branch which is respectively connected in parallel with the branch where the first resistor (Rv) is located and the first branch;
control the selection switch (S2) to close to the control point corresponding to the target charging protocol based on the target charging protocol; wherein the control points corresponding to the charging protocols corresponding to one end of the selection switch (S2) are respectively connected with a resistor, and the other end of the selection switch (S2) is connected with the branch where the second detecting point (DP2) is located;
the voltage collection module (11), the voltage filtering module (12) and the microcontroller (13) that are connected in sequence are further configured to obtain again a voltage target value of the second detecting point (DP2) based on the voltage filtering method for a detecting point;
the switch state determination module (22) is further configured to determine whether the voltage target value of the second detecting point (DP2) that is obtained after the selection switch (S2) is controlled to close meets a third closing condition, and if so, determine that the selection switch (S2) is currently in a closed state.

13. An electronic device comprising a memory (9140), a processor (9100) and a computer program stored in the memory (9140) and capable of running on the processor (9100), wherein the computer program, when being executed by the processor (9100), implements the voltage filtering method for a detecting point according to any one of claims 1 to 2, or the computer program, when being executed by the processor (9100), implements the switch state detection method according to any one of claims 3 to 8.

**Patentansprüche**

1. Spannungsfilterverfahren zur Erkennung eines Schaltungspunktes, aufweisend:

kontinuierliches Erfassen mehrerer Spannungsdaten eines Schaltungspunktes in einer Zielschaltung;
jeweiliges Ermitteln einer Vielzahl von Spannungsfilterwerten, die dem Schaltungspunkt entsprechen, durch Vorausführen von Filtermodi auf der Grundlage der mehreren Spannungsdaten; und
Vergleichen der mehreren Spannungsfilterwerte und, wenn das entsprechende Vergleichsergebnis eine voreingestellte Bedingung erfüllt, Bestimmen eines Spannungszielwerts des Schaltungspunktes auf der Grundlage der mehreren Spannungsfilterwerte,
**dadurch gekennzeichnet, dass** das jeweilige Ermitteln der Vielzahl von Spannungsfilterwerten, die dem Schaltungspunkt entsprechen, durch Anwenden der Filtermodi auf der Grundlage der mehreren Spannungsdaten aufweist:

Durchführen eines Mittelwertfilteralgorithmus, um den Mittelwert der mehreren Spannungsdaten des Schaltungspunktes zu berechnen, um einen Spannungsmittelwert als Spannungsfilterwert des Schaltungspunktes zu erhalten; und

Durchführen eines Medianfilteralgorithmus, um den Medianwert der mehreren Spannungsdaten des Schaltungspunktes zu berechnen, um einen Spannungsmedianwert als einen weiteren Spannungsfilterwert des Schaltungspunktes zu erhalten;

wobei das Vergleichen der Vielzahl von Spannungsfilterwerten und, wenn das entsprechende Vergleichsergebnis die voreingestellte Bedingung erfüllt, das Bestimmen des Spannungszielwerts des Schaltungspunktes auf der Grundlage der Vielzahl von Spannungsfilterwerten aufweist:

Ermitteln eines Differenzwerts zwischen dem Spannungsmittelwert und dem Spannungsmedianwert und Bestimmen, ob der Differenzwert kleiner als der Fehlerschwellwert ist, und wenn ja, Bestimmen des Spannungszielwerts des Schaltungspunktes auf der Grundlage des Spannungsmittelwerts und des Spannungsmedianwerts.

2. Spannungsfilterverfahren zur Erkennung eines Schaltungspunktes nach Anspruch 1, des Weiteren aufweisend: wenn das Vergleichsergebnis die voreingestellte Bedingung nicht erfüllt, erneutes kontinuierliches Erfassen mehrerer Spannungsdaten des Schaltungspunktes und erneutes Ermitteln einer Vielzahl von Spannungsfilterwerten, die dem Schaltungspunkt entsprechen, bis ein erneut ermitteltes Vergleichsergebnis die voreingestellte Bedingung erfüllt und der Spannungszielwert des Schaltungspunktes bestimmt ist.

3. Schaltzustandserkennungsverfahren, aufweisend:

Ermitteln eines Spannungszielwerts eines ersten Schaltungspunktes (DP3) nach dem Schließen eines ersten Schalters (Sv) auf der Grundlage eines Spannungsfilterverfahrens für einen Schaltungspunkt gemäß einem der Ansprüche 1 bis 2, wobei ein Ende des ersten Schalters (Sv) mit einem ersten Widerstand (Rv) in der Steuerungseinheit einer Ladestation verbunden ist und der erste Schaltungspunkt (DP3) am anderen Ende des ersten Schalters (Sv) angeordnet ist; und

Bestimmen, ob der Spannungszielwert des ersten Schaltungspunktes (DP3) eine erste Schließbedingung erfüllt, und wenn ja, Bestimmen, dass sich der erste Schalter (Sv) derzeit in einem geschlossenen Zustand befindet.

4. Schaltzustandserkennungsverfahren nach Anspruch 3, bei dem die Ladestation eine kompatible Ladestation für Fahrzeuge mit neuer Energie ist, die für die Kompatibilität mit mehreren Ladeprotokollen konfiguriert ist.

5. Schaltzustandserkennungsverfahren nach Anspruch 4, bei dem die erste Schließbedingung aufweist:

der Spannungszielwert des ersten Schaltungspunktes (DP3), der nach dem Schließen des ersten Schalters (Sv) erhalten wird, nicht gleich dem Spannungszielwert des ersten Schaltungspunktes (DP3) ist, der vor dem Schließen des ersten Schalters (Sv) erhalten wurde, und der Spannungszielwert des ersten Schaltungspunktes (DP3), der nach dem Schließen des ersten Schalters (Sv) erhalten wird, innerhalb des Spannungsbereichs, der einem der beiden Ladeprotokolle entspricht, liegt,

oder

wobei das Schaltzustandserkennungsverfahren nach der Bestimmung, dass sich der erste Schalter (Sv) derzeit im geschlossenen Zustand befindet, des Weiteren aufweist:

Bestimmen eines Soll-Ladeprotokolls, das dem Spannungszielwert entspricht, basierend auf einem voreingestellten Spannungsbereich, der jedem der Ladeprotokolle entspricht.

6. Schaltzustandserkennungsverfahren nach Anspruch 4, bei dem das Schaltzustandserkennungsverfahren nach der Bestimmung, dass sich der erste Schalter (Sv) derzeit im geschlossenen Zustand befindet, des Weiteren aufweist:

Bestimmen eines dem Spannungszielwert entsprechenden Ziel-Ladeprotokolls auf der Grundlage eines voreingestellten Spannungsbereichs, der jedem der Ladeprotokolle entspricht, und

nach dem Bestimmen des dem Spannungszielwert entsprechenden Ziel-Ladeprotokolls das Schaltzustandserkennungsverfahren des Weiteren aufweist:

Empfangen einer Schließanweisung für den zweiten Schalter (S2') und Steuern des zweiten Schalters (S2'), um ihn zu schließen, wobei ein Ende des zweiten Schalters (S2') in Reihe mit dem zweiten Widerstand (R4') in der Steuerungseinheit geschaltet ist, um einen ersten Zweig zu bilden, wobei der erste Zweig parallel zu einem Zweig geschaltet ist, in dem sich der erste Widerstand (Rv) befindet;

Ermitteln eines Spannungszielwerts des zweiten Schaltungspunktes (DP2) auf der Grundlage des Spannungsfilterverfahrens für einen Schaltungspunkt, wobei ein Zweig, in dem sich der zweite Schaltungspunkt (DP2) befindet, mit dem ersten Zweig verbunden ist;

Bestimmen, ob der Spannungszielwert des zweiten Schaltungspunkts (DP2) eine zweite Schließbedingung erfüllt, und wenn ja, Bestimmen, dass sich der zweite Schalter (S2') derzeit in einem geschlossenen Zustand befindet.

7. Schaltzustandserkennungsverfahren nach Anspruch 6, wobei die zweite Schließbedingung aufweist:
der Spannungszielwert des zweiten Schaltungspunktes (DP2), der nach dem Schließen des zweiten Schalters (S2') erhalten wird, nicht gleich dem Spannungszielwert des zweiten Schaltungspunktes (DP2) ist, der vor dem Schließen des zweiten Schalters (S2') im Voraus erhalten wurde.

8. Schaltzustandserkennungsverfahren nach Anspruch 6, bei dem Schaltzustandserkennungsverfahren nach der Bestimmung, dass sich der zweite Schalter (S2') derzeit in einem geschlossenen Zustand befindet, des Weiteren aufweist:

Empfangen einer Schließanweisung für einen Auswahlschalter (S2), wobei der Auswahlschalter (S2) auf einem zweiten Zweig angeordnet ist, der jeweils parallel zu dem Zweig, auf dem sich der erste Widerstand (Rv) befindet, und dem ersten Zweig geschaltet ist;

Steuern des Auswahlschalters (S2), um ihn entsprechend dem Ziel-Ladeprotokoll auf den dem Ziel-Ladeprotokoll entsprechenden Steuerpunkt zu schließen; wobei die den Ladeprotokollen entsprechenden Steuerpunkte, die einem Ende des Auswahlschalters (S2) entsprechen, jeweils mit einem Widerstand verbunden sind und das andere Ende des Auswahlschalters (S2) mit dem Zweig verbunden ist, in dem sich der zweite Schaltungspunkt (DP2) befindet;

erneutes Ermitteln eines Spannungszielwerts des zweiten Schaltungspunktes (DP2) auf der Grundlage des Spannungsfilterverfahrens für den Schaltungspunkt;

Bestimmen, ob der Spannungszielwert des zweiten Schaltungspunkts (DP2), der nach dem Schließen des Auswahlschalters (S2) erhalten wird, eine dritte Schließbedingung erfüllt, und wenn ja, Bestimmen, dass sich der Auswahlschalter (S2) derzeit in einem geschlossenen Zustand befindet;

vorzugsweise wobei

die dritte Schließbedingung aufweist:

der Spannungszielwert des zweiten Schaltungspunktes (DP2), der nach dem Schließen des Auswahlschalters (S2) erhalten wird, nicht gleich dem Spannungszielwert des zweiten Schaltungspunktes (DP2) ist, der vor dem Schließen des Auswahlschalters (S2) erhalten wurde.

9. Spannungsfiltervorrichtung für einen Schaltungspunkt, aufweisend:

ein Spannungserfassungsmodul (11), das so konfiguriert ist, dass es kontinuierlich mehrere Spannungsdaten eines Schaltungspunkts in einer Zielschaltung erfasst;

ein Spannungsfiltermodul (12), das so konfiguriert ist, dass es jeweils mehrere Spannungsfilterwerte entsprechend dem Schaltungspunkt erhält, indem es Filtermodi auf der Grundlage der mehreren Spannungsdaten ausführt; und

einen Mikrocontroller (13), der so konfiguriert ist, dass er die mehreren Spannungsfilterwerte vergleicht und, wenn das entsprechende Vergleichsergebnis eine voreingestellte Bedingung erfüllt, einen Spannungszielwert des Schaltungspunkts auf der Grundlage der mehreren Spannungsfilterwerte bestimmt, **dadurch gekennzeichnet, dass** das Spannungsfiltermodul (12) aufweist:

eine Mittelwertfiltereinheit, die so konfiguriert ist, dass sie einen Mittelwertfilteralgorithmus ausführt, um den Mittelwert der mehreren Spannungsdaten des Schaltungspunktes zu berechnen, um einen Spannungsmittelwert als Spannungsfilterwert des Schaltungspunktes zu erhalten; und

eine Medianfiltereinheit, die so konfiguriert ist, dass sie einen Medianfilteralgorithmus ausführt, um den Medianwert der mehreren Spannungsdaten des Schaltungspunktes zu berechnen, um einen Spannungsmedianwert als einen weiteren Spannungsfilterwert des Schaltungspunktes zu erhalten;

wobei der Mikrocontroller (13) aufweist:

eine Fehlerbestimmungseinheit, die so konfiguriert ist, dass sie einen Differenzwert zwischen dem Spannungsmittelwert und dem Spannungsmedianwert ermittelt und bestimmt, ob der Differenzwert kleiner als der Fehlerschwellwert ist, und wenn dies der Fall ist, den Spannungszielwert des Schaltungspunktes auf der Grundlage des Spannungsmittelwerts und des Spannungsmedianwerts bestimmt.

10. Spannungsfiltervorrichtung für einen Schaltungspunkt nach Anspruch 9, bei der der Mikrocontroller (13) des Weiteren so konfiguriert ist, dass er den folgenden Vorgang ausführt:
wenn das Vergleichsergebnis die voreingestellte Bedingung nicht erfüllt, Steuern des Spannungserfassungsmoduls (11) derart, dass es wiederholt mehrere Spannungsdaten des Schaltungspunktes erfasst, und Steuern des Spannungsfiltermoduls (12) derart, dass es wiederholt mehrere Spannungsfilterwerte entsprechend dem Schaltungspunkt ermittelt, bis ein vom Mikrocontroller (13) ermitteltes Vergleichsergebnis wieder die voreingestellte Bedingung erfüllt und der Spannungszielwert des Schaltungspunktes bestimmt ist.

11. Schaltzustandserkennungssystem, aufweisend:

eine Spannungsfiltervorrichtung für einen Schaltungspunkt, die so konfiguriert ist, dass sie einen Spannungszielwert eines ersten Schaltungspunktes (DP3) nach dem Schließen eines ersten Schalters (Sv) auf der Grundlage eines Spannungsfilterverfahrens für einen Schaltungspunkt gemäß einem der Ansprüche 1 bis 2 ermittelt, wobei ein Ende des ersten Schalters (Sv) mit einem ersten Widerstand (Rv) in der Steuerungseinheit einer Ladestation verbunden ist und der erste Schaltungspunkt (DP3) am anderen Ende des ersten Schalters (Sv) angeordnet ist; und
ein Schaltzustandsbestimmungsmodul (22), das so konfiguriert ist, dass es bestimmt, ob der Spannungszielwert des ersten Schaltungspunktes (DP3) eine erste Schließbedingung erfüllt, und wenn ja, bestimmt, dass sich der erste Schalter (Sv) derzeit in einem geschlossenen Zustand befindet.

12. Schaltzustandserkennungssystem nach Anspruch 11, bei dem die Ladestation eine kompatible Ladestation für Fahrzeuge mit neuer Energie ist, die für die Kompatibilität mit mehreren Ladeprotokollen konfiguriert ist;

vorzugsweise
des Weiteren aufweisend: ein
Protokollidentifizierungsmodul (23), das so konfiguriert ist, dass es ein Ziel-Ladeprotokoll entsprechend dem Spannungszielwert auf der Grundlage eines voreingestellten Spannungsbereichs, der jedem der Ladeprotokolle entspricht, bestimmt,
vorzugsweise wobei
die Spannungsfiltervorrichtung für einen Schaltungspunkt in einer Schaltung ein Spannungserfassungsmodul (11), ein Spannungsfiltermodul (12) und einen Mikrocontroller (13) aufweist, die in Reihe geschaltet sind;
der Mikrocontroller (13) des Weiteren so konfiguriert ist, dass er einen Schließbefehl für den zweiten Schalter (S2') empfängt und den zweiten Schalter (S2') so steuert, dass er schließt, wobei ein Ende des zweiten Schalters (S2') in Reihe mit dem zweiten Widerstand (R4') in der Steuerungseinheit geschaltet ist, um einen ersten Zweig zu bilden, der erste Zweig parallel zu dem Zweig geschaltet ist, in dem sich der erste Widerstand (Rv) befindet;
das Spannungserfassungsmodul (11), das
Spannungsfiltermodul (12) und der Mikrocontroller (13), die in Reihe geschaltet sind, des Weiteren so konfiguriert sind, dass sie einen Spannungszielwert des zweiten Schaltungspunktes (DP2) auf der Grundlage des Spannungsfilterverfahrens für einen Schaltungspunkt erhalten, wobei der Zweig, in dem sich der zweite Schaltungspunkt (DP2) befindet, mit dem ersten Zweig verbunden ist;
das Schaltzustandsbestimmungsmodul (22) des Weiteren so konfiguriert ist, dass es ermittelt, ob der Spannungszielwert des zweiten Schaltungspunktes (DP2) eine zweite Schließbedingung erfüllt, und wenn ja, feststellt, dass sich der zweite Schalter (S2') derzeit in einem geschlossenen Zustand befindet,
vorzugsweise wobei
der Mikrocontroller (13) des Weiteren so konfiguriert ist, dass er einen Schließbefehl für einen Auswahlschalter (S2) empfängt, wobei der Auswahlschalter (S2) auf einem zweiten Zweig angeordnet ist, der jeweils parallel zu dem Zweig, auf dem sich der erste Widerstand (Rv) befindet, und dem ersten Zweig geschaltet ist;
Steuerung des Auswahlschalters (S2), um ihn entsprechend dem Ziel-Ladeprotokoll auf den dem Ziel-Ladeprotokoll entsprechenden Steuerpunkt zu schließen; wobei die Steuerpunkte, die den Ladeprotokollen entsprechen, die einem Ende des Auswahlschalters (S2) entsprechen, jeweils mit einem Widerstand verbunden sind und das andere Ende des Auswahlschalters (S2) mit dem Zweig verbunden ist, in dem sich der zweite Schaltungspunkt (DP2) befindet;
das Spannungserfassungsmodul (11), das
Spannungsfiltermodul (12) und der Mikrocontroller (13), die in Reihe geschaltet sind, des Weiteren so konfiguriert sind, dass sie erneut einen Spannungszielwert des zweiten Schaltungspunktes (DP2) auf der Grundlage des Spannungsfilterverfahrens für einen Schaltungspunkt erhalten;

das Schaltzustandsbestimmungsmodul (22) des Weiteren so konfiguriert ist, dass es ermittelt, ob der Spannungszielwert des zweiten Schaltungspunktes (DP2), der nach dem Schließen des Auswahlschalters (S2) ermittelt wird, eine dritte Schließbedingung erfüllt, und wenn ja, feststellt, dass sich der Auswahlschalter (S2) derzeit in einem geschlossenen Zustand befindet.

13. Elektronisches Gerät, das einen Speicher (9140), einen Prozessor (9100) und ein in dem Speicher (9140) gespeichertes und auf dem Prozessor (9100) ausführbares Computerprogramm aufweist, wobei das Computerprogramm, wenn es von dem Prozessor (9100) ausgeführt wird, das Spannungsfilterverfahren für einen Schaltungspunkt gemäß einem der Ansprüche 1 bis 2 implementiert, oder das Computerprogramm, wenn es vom Prozessor (9100) ausgeführt wird, das Schaltzustandserkennungsverfahren gemäß einem der Ansprüche 3 bis 8 implementiert.

**Revendications**

1. Procédé de filtrage de tension pour détecter un point de commutation dans un circuit, comprenant:

acquérir en continu d'une pluralité de données de tension d'un point de commutation dans un circuit cible;

déterminer respectivement d'une pluralité de valeurs de filtrage de tension correspondant au point de commutation en exécutant à l'avance des modes de filtrage sur la base des multiples données de tension; et

comparer des multiples valeurs de filtrage de tension et, lorsque le résultat de la comparaison correspondante satisfait à une condition prédéfinie, la détermination d'une valeur de tension cible du point de commutation sur la base des multiples valeurs de filtrage de tension,

**caractérisé en ce que** la détermination respective de la pluralité de valeurs de filtrage de tension correspondant au point de circuit comprend, en appliquant les modes de filtrage sur la base de la pluralité de données de tension:

exécuter d'un algorithme de filtrage de moyenne pour calculer la moyenne de la pluralité de données de tension du point de circuit afin d'obtenir une moyenne de tension comme valeur de filtre de tension du point de circuit; et

exécuter d'un algorithme de filtrage médian pour calculer la valeur médiane de la pluralité de données de tension du point de commutation afin d'obtenir une valeur médiane de tension comme autre valeur de filtrage de tension du point de commutation;

la comparaison de la pluralité de valeurs de filtrage de tension et, si le résultat de la comparaison correspondante satisfait à la condition prédéfinie, la détermination de la valeur cible de tension du point de circuit sur la base de la pluralité de valeurs de filtrage de tension comprenant:

déterminer une valeur différentielle entre la valeur moyenne de tension et la valeur médiane de tension et déterminer si la valeur différentielle est inférieure à la valeur seuil d'erreur, et si oui, déterminer la valeur cible de tension du point de commutation sur la base de la valeur moyenne de tension et de la valeur médiane de tension.

2. Procédé de filtrage de tension pour détecter un point de commutation selon la revendication 1, comprenant en outre: si le résultat de la comparaison ne satisfait pas à la condition prédéfinie, une nouvelle acquisition continue de plusieurs données de tension du point de commutation et une nouvelle détermination d'une pluralité de valeurs de filtrage de tension correspondant au point de commutation jusqu'à ce qu'un nouveau résultat de comparaison satisfasse à la condition prédéfinie et que la valeur de tension cible du point de commutation soit déterminée.

3. Procédé de détection d'état de commutateur, comprenant:

déterminer d'une valeur de tension cible d'un premier point de commutation (DP3) après la fermeture d'un premier commutateur (Sv) sur la base d'un procédé de filtrage de tension pour détecter un point de commutation selon l'une des revendications 1 à 2, une extrémité du premier commutateur (Sv) étant connectée à une première résistance (Rv) dans l'unité de commande d'une station de charge et le premier point de commutation (DP3) étant situé à l'autre extrémité du premier commutateur (Sv); et

déterminer si la valeur cible de tension du premier point de commutation (DP3) remplit une première condition de fermeture et, si oui, déterminer que le premier commutateur (Sv) se trouve actuellement dans un état fermé.

4. Procédé de détection d'état de commutateur selon la revendication 3, dans lequel la station de recharge est une station de recharge compatible pour les véhicules à énergie nouvelle de type, configurée pour être compatible avec plusieurs protocoles de recharge.

5. Procédé de détection d'état de commutateur selon la revendication 4, dans lequel la première condition de fermeture comprend:

la valeur cible de tension du premier point de commutation (DP3) obtenue après la fermeture du premier commutateur (Sv) n'est pas égale à la valeur cible de tension du premier point de commutation (DP3) obtenue avant la fermeture du premier commutateur (Sv), et la valeur cible de tension du premier point de commutation (DP3) obtenue après la fermeture du premier commutateur (Sv) se situe dans la plage de tension correspondant à l'un des deux protocoles de charge,
ou
le Procédé de détection d'état de commutateur, après avoir déterminé que le premier commutateur (Sv) est actuellement à l'état fermé, comprenant en outre:
déterminer d'un protocole de charge cible correspondant à la valeur de tension cible, sur la base d'une plage de tension prédéfinie correspondant à chacun des protocoles de charge.

6. Procédé de détection d'état de commutateur selon la revendication 4, dans lequel le Procédé de détection d'état de commutateur, après avoir déterminé que le premier commutateur (Sv) est actuellement à l'état fermé, comprend en outre:

déterminer d'un protocole de charge cible correspondant à la valeur de tension cible sur la base d'une plage de tension prédéfinie correspondant à chacun des protocoles de charge, et
après la détermination du protocole de charge cible correspondant à la valeur de tension cible, le procédé de détection d'état de commutateur comprend en outre:

recevoir d'une instruction de fermeture pour le deuxième commutateur (S2') et la commande du deuxième commutateur (S2') pour le fermer, une extrémité du deuxième commutateur (S2') étant connectée en série avec la deuxième résistance (R4') dans l'unité de commande pour former une première branche, la première branche étant connectée en parallèle avec une branche dans laquelle se trouve la première résistance (Rv);
déterminer d'une valeur cible de tension du deuxième point de commutation (DP2) sur la base du procédé de filtrage de tension pour détecter un point de commutation, une branche dans laquelle se trouve le deuxième point de commutation (DP2) étant connectée à la première branche;
déterminer si la valeur cible de tension du deuxième point de circuit (DP2) satisfait à une deuxième condition de fermeture et, si oui, détermination que le deuxième commutateur (S2') se trouve actuellement dans un état fermé.

7. Procédé de détection d'état de commutateur selon la revendication 6, dans lequel la deuxième condition de fermeture comprend:
la valeur de tension cible du deuxième point de commutation (DP2) obtenue après la fermeture du deuxième commutateur (S2') n'est pas égale à la valeur de tension cible du deuxième point de commutation (DP2) obtenue à l'avance avant la fermeture du deuxième commutateur (S2').

8. Procédé de détection d'état de commutateur selon la revendication 6, dans lequel le procédé de détection d'état de commutateur, après avoir déterminé que le deuxième commutateur (S2') se trouve actuellement dans un état fermé, comprend en outre:

recevoir d'une instruction de fermeture pour un commutateur de sélection (S2), le commutateur de sélection (S2) étant disposé sur une deuxième branche qui est connectée en parallèle à la branche sur laquelle se trouve la première résistance (Rv) et à la première branche;
commander le commutateur de sélection (S2) afin de le fermer conformément au protocole de charge cible sur le point de commande correspondant au protocole de charge cible; les points de commande correspondant aux protocoles de charge, qui correspondent à une extrémité du commutateur de sélection (S2), étant chacun connectés à une résistance, et l'autre extrémité du commutateur de sélection (S2) étant connectée à la branche dans laquelle se trouve le deuxième point de commutation (DP2);
déterminer à nouveau une valeur de tension cible du deuxième point de commutation (DP2) sur la base du procédé de filtrage de tension pour le point de commutation;

déterminer si la valeur cible de tension du deuxième point de commutation (DP2) obtenue après la fermeture du commutateur de sélection (S2) remplit une troisième condition de fermeture et, si oui, détermination que le commutateur de sélection (S2) se trouve actuellement dans un état fermé;
de préférence
la troisième condition de fermeture comprend:
la valeur cible de tension du deuxième point de commutation (DP2) obtenue après la fermeture du commutateur de sélection (S2) n'est pas égale à la valeur cible de tension du deuxième point de commutation (DP2) obtenue avant la fermeture du commutateur de sélection (S2).

9. Appareil de filtrage de tension pour un point de commutation, comprenant:

un module de détection de tension (11) configuré pour détecter en continu une pluralité de données de tension d'un point de commutation dans un circuit cible;
un module de filtrage de tension (12) configuré pour obtenir respectivement plusieurs valeurs de filtrage de tension correspondant au point de commutation en exécutant des modes de filtrage sur la base des multiples données de tension; et
un microcontrôleur (13) configuré pour comparer les multiples valeurs de filtrage de tension et, lorsque le résultat de la comparaison correspondante satisfait à une condition prédéfinie, déterminer une valeur de tension cible du point de circuit sur la base des multiples valeurs de filtrage de tension,
**caractérisé en ce que** le module de filtrage de tension (12) comprend:

une unité de filtrage de moyenne configurée pour exécuter un algorithme de filtrage de moyenne afin de calculer la moyenne des multiples données de tension du point de circuit afin d'obtenir une moyenne de tension comme valeur de filtrage de tension du point de circuit; et
une unité de filtrage médian configurée pour exécuter un algorithme de filtrage médian afin de calculer la valeur médiane de la pluralité de données de tension du point de commutation afin d'obtenir une valeur médiane de tension comme autre valeur de filtrage de tension du point de commutation;
le microcontrôleur (13) comprenant:
une unité de détermination d'erreur configurée pour déterminer une valeur de différence entre la valeur moyenne de tension et la valeur médiane de tension et pour déterminer si la valeur de différence est inférieure à la valeur seuil d'erreur, et si tel est le cas, pour déterminer la valeur cible de tension du point de circuit sur la base de la valeur moyenne de tension et de la valeur médiane de tension.

10. Appareil de filtrage de tension pour un point de commutation selon la revendication 9, dans lequel le microcontrôleur (13) est en outre configuré pour exécuter l'opération suivante:
si le résultat de la comparaison ne remplit pas la condition prédéfinie, commande du module de détection de tension (11) de telle sorte qu'il détecte de manière répétée plusieurs données de tension du point de commutation, et commande le module de filtrage de tension (12) de manière à déterminer de manière répétée plusieurs valeurs de filtrage de tension correspondant au point de commutation, jusqu'à ce qu'un résultat de comparaison déterminé par le microcontrôleur (13) remplisse à nouveau la condition prédéfinie et que la valeur de tension cible du point de commutation soit déterminée.

11. Système de détection d'état de commutation, comprenant:

un appareil de filtrage de tension pour un point de commutation, qui est configuré de manière à déterminer une valeur de tension cible d'un premier point de commutation (DP3) après la fermeture d'un premier commutateur (Sv) sur la base d'un procédé de filtrage de tension pour un point de commutation selon l'une des revendications 1 à 2, une extrémité du premier commutateur (Sv) étant connectée à une première résistance (Rv) dans l'unité de commande d'une station de charge, et le premier point de commutation (DP3) étant situé à l'autre extrémité du premier commutateur (Sv); et
un module de détermination de l'état de commutation (22) configuré pour déterminer si la valeur cible de tension du premier point de commutation (DP3) satisfait à une première condition de fermeture et, si tel est le cas, pour déterminer que le premier commutateur (Sv) est actuellement dans un état fermé.

12. Système de détection d'état de commutation selon la revendication 11, dans lequel la station de recharge est une station de recharge compatible pour véhicules à énergie nouvelle, configurée pour être compatible avec plusieurs protocoles de recharge;

de préférence

comprenant en outre: un module d'identification de protocole (23) configuré pour déterminer un protocole de charge cible correspondant à la valeur cible de tension sur la base d'une plage de tension prédéfinie correspondant à chacun des protocoles de charge,

de préférence

le dispositif de filtrage de tension comprend, pour un point de commutation dans un circuit, un module de détection de tension (11), un module de filtrage de tension (12) et un microcontrôleur (13) connectés en série; le microcontrôleur (13) est en outre configuré pour recevoir une commande de fermeture pour le deuxième commutateur (S2') et commande le deuxième commutateur (S2') pour qu'il se ferme, une extrémité du deuxième commutateur (S2') étant connectée en série avec la deuxième résistance (R4') dans l'unité de commande pour former une première branche, la première branche étant connectée en parallèle avec la branche dans laquelle se trouve la première résistance (Rv) ;

le module de détection de tension (11), le module de filtrage de tension (12) et le microcontrôleur (13), qui sont connectés en série, sont en outre configurés pour obtenir une valeur cible de tension du deuxième point de commutation (DP2) sur la base du procédé de filtrage de tension pour un point de commutation, la branche dans laquelle se trouve le deuxième point de commutation (DP2) étant connectée à la première branche;

le module de détermination d'état de commutation (22) étant en outre configuré pour déterminer si la valeur cible de tension du deuxième point de commutation (DP2) satisfait à une deuxième condition de fermeture et, si tel est le cas, pour déterminer que le deuxième commutateur (S2') est actuellement dans un état fermé,

de préférence

le microcontrôleur (13) est en outre configuré pour recevoir une commande de fermeture pour un commutateur de sélection (S2), le commutateur de sélection (S2) étant disposé sur une deuxième branche qui est connectée en parallèle à la branche sur laquelle se trouve la première résistance (Rv) et à la première branche;

commander du commutateur de sélection (S2) afin de le fermer sur le point de commande correspondant au protocole de charge cible ; les points de commande correspondant aux protocoles de charge correspondant à une extrémité du commutateur de sélection (S2) étant respectivement connectés à une résistance et l'autre extrémité du commutateur de sélection (S2) étant connectée à la branche dans laquelle se trouve le deuxième point de commutation (DP2);

le module de détection de tension (11), le module de filtrage de tension (12) et le microcontrôleur (13), qui sont connectés en série, sont en outre configurés pour obtenir à nouveau une valeur cible de tension du deuxième point de commutation (DP2) sur la base du procédé de filtrage de tension pour un point de commutation;

le module de détermination de l'état de commutation (22) étant en outre configuré pour déterminer si la valeur cible de tension du deuxième point de commutation (DP2), qui est déterminée après la fermeture du commutateur de sélection (S2), satisfait à une troisième condition de fermeture et, si tel est le cas, pour déterminer que le commutateur de sélection (S2) est actuellement dans un état fermé.

13. Appareil électronique comprenant une mémoire (9140), un processeur (9100) et un programme informatique stocké dans la mémoire (9140) et exécutable sur le processeur (9100), dans lequel le programme informatique, lorsqu'il est exécuté par le processeur (9100), met en œuvre le procédé de filtrage de tension pour un point de commutation selon l'une des revendications 1 à 2, ou le programme informatique, lorsqu'il est exécuté par le processeur (9100), met en œuvre le procédé de détection d'état de commutateur selon l'une des revendications 3 à 8.

Continuously collecting multiple voltage data of a detecting point in a target circuit — 110

Respectively obtaining a plurality of voltage filtering values corresponding to the detecting point by preforming a filter modes based on the multiple voltage data — 120

Comparing the plurality of voltage filtering values to obtain a corresponding comparison result — 130

If the comparison result meets a preset condition, determining a voltage target value of the detecting point based on the plurality of voltage filtering values — 140

FIG. 1

Continuously collecting multiple voltage data of a detecting point in a target circuit — 110

Respectively obtaining a plurality of voltage filtering values corresponding to the detecting point by preforming a filter modes based on the multiple voltage data — 120

Comparing the plurality of voltage filtering values to obtain a corresponding comparison result — 130

If the comparison result meets a preset condition, determining a voltage target value of the detecting point based on the plurality of voltage filtering values — 140

If the comparison result does not meet a preset condition, determining the voltage filtering result for the detecting point to be invalid — 150

FIG. 2

Continuously collecting multiple voltage data of a detecting point in a target circuit — 110

Performing a mean filter algorithm to calculate the mean value of the plurality of voltage data of the detecting point, to obtain a voltage mean value as a voltage filtering value of the detecting point — 121

Performing a median filter algorithm to calculate the median value of the plurality of voltage data of the detecting point, to obtain a voltage median value as another voltage filtering value of the detecting point — 122

Comparing the plurality of voltage filtering values to obtain a corresponding comparison result — 130

If the comparison result meets a preset condition, determining a voltage target value of the detecting point based on the plurality of voltage filtering values — 140

If the comparison result does not meet a preset condition, determining the voltage filtering result for the detecting point to be invalid — 150

FIG. 3

110

Continuously collecting multiple voltage data of a detecting point in a target circuit

Performing a mean filter algorithm to calculate the mean value of the plurality of voltage data of the detecting point, to obtain a voltage mean value as a voltage filtering value of the detecting point

121

Performing a median filter algorithm to calculate the median value of the plurality of voltage data of the detecting point, to obtain a voltage median value as another voltage filtering value of the detecting point

122

Obtaining a difference value between the voltage mean value and the voltage median value and determining whether the difference value is smaller than the error threshold value

131

YES

NO

If the comparison result meets a preset condition, determining a voltage target value of the detecting point based on the plurality of voltage filtering values

141

If the comparison result does not meet a preset condition, determining the voltage filtering result for the detecting point to be invalid

151

FIG. 4

210

Obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch

220

Determining whether the voltage target value of the first detecting point meets a first closing condition, and if so, determining that the first switch is currently in a closed state

FIG. 5

R4', 2.74kΩ

R4c', 1.0kΩ

R4c, 200Ω

R4, 1.3kΩ

U2, 12 V

R3', 100kΩ

S2'

3    2
1
S2    0

Rv, 1.0kΩ

Detecting Point 2

Detecting Point 3

Sv

FIG. 2

FIG. 6

210

Obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch

220

Determining whether the voltage target value of the first detecting point meets a first closing condition, and if so, determining that the first switch is currently in a closed state

230

Determining the target charging protocol corresponding to the voltage target value based on the preset voltage range corresponding to each of the charging protocols

FIG. 7

210

Obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch

220

Determining whether the voltage target value of the first detecting point meets a first closing condition, and if so, determining that the first switch is currently in a closed state

230

Determining the target charging protocol corresponding to the voltage target value based on the preset voltage range corresponding to each of the charging protocols

241

Receiving a closing instruction for the second switch and controlling the second switch to close, wherein one end of the second switch is connected in series with the second resistor in the control guidance unit to form a first branch, the first branch is connected in parallel with a branch where the first resistor is located

242

Obtaining a voltage target value of the second detecting point based on the voltage filtering method for a detecting point, and, a branch where the second detecting point is located is connected with the first branch

243

Determining whether the voltage target value of the second detecting point meets a second closing condition, and if so, determining that the second switch is currently in a closed state

FIG. 8

**EP 4 375 681 B1**

210

Obtaining a voltage target value of a first detecting point after controlling a first switch to be closed, based on the voltage filtering method for a detecting point, and one end of the first switch is connected with a first resistor in the control guidance unit of a charging base, and the first detecting point is arranged at the other end of the first switch

220

Determining whether the voltage target value of the first detecting point meets a first closing condition, and if so, determining that the first switch is currently in a closed state

230

Determining the target charging protocol corresponding to the voltage target value based on the preset voltage range corresponding to each of the charging protocols

241

Receiving a closing instruction for the second switch and controlling the second switch to close, wherein one end of the second switch is connected in series with the second resistor in the control guidance unit to form a first branch, the first branch is connected in parallel with a branch where the first resistor is located

242

Obtaining a voltage target value of the second detecting point based on the voltage filtering method for a detecting point, and, a branch where the second detecting point is located is connected with the first branch

243

Determining whether the voltage target value of the second detecting point meets a second closing condition, and if so, determining that the second switch is currently in a closed state

251

Receiving a closing instruction for the selection switch, the selection switch is arranged on a second branch which is respectively connected in parallel with the branch where the first resistor is located and the first branch

252

Controlling the selection switch to close to the control point corresponding to the target charging protocol based on the target charging protocol; the control points corresponding to the charging protocols corresponding to one end of the selection switch are respectively connected with a resistor, and the other end of the selection switch is connected with the branch where the second detecting point is located

253

Obtaining again a voltage target value of the second detecting point based on the voltage filtering method for the detecting point

254

Determining whether the voltage target value of the second detecting point that is obtained after the selection switch is controlled to close meets a third closing condition, and if so, determining that the selection switch is currently in a closed state

FIG. 9

32

Voltage filtering apparatus for a
detecting point in a circuit

11

12

13

| Voltage collection module | Voltage filtering module | Microcontroller |

FIG. 10

Switch state detection system

21

22

Voltage filtering apparatus for a
detecting point in a circuit

11

12

13

| Voltage collection module | Voltage filtering module | Microcontroller |

Switch state determination module

FIG. 11

Switch state detection system

21

23

Voltage filtering apparatus for a
detecting point in a circuit

11

12

13

| Voltage collection module | Voltage filtering module | Microcontroller |

Protocol identification module

22

Switch state determination module

FIG. 12

FIG. 13

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110839634
- CN 110988448 A
- CN 112098820 A